# EUROPEAN PATENT APPLICATION

(11) **EP 4 804 782 A1**
(43) Date of publication of application: **09.09.2026**
(21) Application number: 26152235.3
(22) Date of filing: 16.01.2026
(51) Int. Cl.: H10W 10/17, H10W 10/00, H10W 20/40, H10D 30/00, H10D 62/10, H10D 64/23, H10D 84/01, H10D 84/83, H10W 20/45, H10D 64/01

(54) **SEMICONDUCTOR DEVICE AND METHOD FOR FABRICATING THEREOF**

(30) Priority: 04.03.2025 KR 20250027609
(71) Applicant: Samsung Electronics Co., Ltd., Suwon-si, Gyeonggi-do 16677 (KR)
(72) Inventor: LEE, Hyung Goo, 16677 Suwon-si (KR); KOH, Kyong Beom, 16677 Suwon-si (KR); KIM, Gwan Ho, 16677 Suwon-si (KR); KIM, Ki-Il, 16677 Suwon-si (KR)
(74) Representative: Marks & Clerk LLP

(57) **Abstract**

A semiconductor device includes a backside wiring line including a first side and a second side opposite to the first side in a first direction, a lower pattern on the first side of the backside wiring line, the lower pattern including a first side and a second side opposite to the first side in the first direction, where the second side of the lower pattern faces the backside wiring line, a sheet pattern on the first side of the lower pattern, and that is spaced apart from the lower pattern in the first direction, a first source/drain pattern on the lower pattern and connected to the sheet pattern, and an active region insulating pattern contacting the lower pattern, the active region insulating pattern including a line portion and a protruding portion, the line portion of the active region insulating pattern extending along the second side of the lower pattern.

## Description

### BACKGROUND

### 1. Field

The present disclosure relates to a semiconductor device and a method for fabricating the same, and more specifically, to a semiconductor device including a Multi-Bridge Channel Field Effect Transistor (MBCFET^{™}) and a method for fabricating the same.

### 2. Description of Related Art

As one of scaling technologies for increasing density of a semiconductor device, a multi gate transistor in which a multi-channel active pattern (or a silicon body) of a fin or nanowire shape is formed on a substrate and a gate is formed on a surface of the multi-channel active pattern has been proposed.

Since such a multi gate transistor utilizes a three-dimensional channel, scaling is easily performed. Further, even if a gate length of the multi gate transistor is not increased, the current control capability may be improved. Furthermore, a short channel effect (SCE) in which potential of a channel region is influenced by a drain voltage may be effectively suppressed.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor device that may be capable of improved element performance and reliability, and a method of manufacturing the same.

Additional aspects will be set forth in part in the description which follows and, in part, will be apparent from the description, or may be learned by practice of the presented embodiments.

According to an aspect of an example embodiment, a semiconductor device may include a backside wiring line including a first side and a second side opposite to the first side in a first direction, a lower pattern on the first side of the backside wiring line, the lower pattern including a first side and a second side opposite to the first side in the first direction, where the second side of the lower pattern faces the backside wiring line, a sheet pattern on the first side of the lower pattern, and that is spaced apart from the lower pattern in the first direction, a first source/drain pattern on the lower pattern and connected to the sheet pattern, an active region insulating pattern contacting the lower pattern, the active region insulating pattern including a line portion and a protruding portion, the line portion of the active region insulating pattern extending along the second side of the lower pattern, and the protruding portion of the active region insulating pattern protruding from the line portion of the active region insulating pattern toward the sheet pattern, and a backside source/drain contact connected to the first source/drain pattern and the backside wiring line, the backside source/drain contact being below the first source/drain pattern in the first direction.

According to an aspect of an example embodiment, a semiconductor device may include a backside wiring line including a first side and a second side opposite to the first side in a first direction, a lower pattern on the first side of the backside wiring line, the lower pattern including a first side and a second side opposite to the first side in the first direction, where the second side of the lower pattern faces the backside wiring line, a sheet pattern on the first side of the lower pattern, and that is spaced apart from the lower pattern in the first direction, a first source/drain pattern contacting the lower pattern and connected to the sheet pattern, a gate structure on the first side of the lower pattern, the gate structure including a gate insulating film and a gate electrode that enclose the sheet pattern, where the gate electrode extends in a second direction intersecting the first direction, an active region insulating pattern contacting the lower pattern and the gate structure, and a backside source/drain contact connected to the first source/drain pattern and the backside wiring line, the backside source/drain contact extending through the active region insulating pattern, and being below the first source/drain pattern in the first direction.

According to an aspect of an example embodiment, a semiconductor device may include a backside wiring line including a first side and a second side opposite to the first side in a first direction, a lower pattern on the first side of the backside wiring line, the lower pattern including a first side and a second side opposite to the first side in the first direction, where the second side of the lower pattern faces the backside wiring line, a sheet pattern on the first side of the lower pattern, and that is spaced apart from the lower pattern in the first direction, a first source/drain pattern contacting the lower pattern and connected to the sheet pattern, a gate structure on the first side of the lower pattern, the gate structure including a gate insulating film and a gate electrode that enclose the sheet pattern, where the gate electrode extends in a second direction intersecting the first direction, an active region insulating pattern contacting the lower pattern and the gate structure, and a backside source/drain contact connected to the first source/drain pattern and the backside wiring line, and the backside source/drain contact being below the first source/drain pattern in the first direction, where the second side of the lower pattern is above a surface of the active region insulating pattern in the first direction.

At least some of the above and other features of the invention are set out in the claims.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram illustrating the semiconductor device according to one or more embodiments;
FIGS. 2, 3, 4, 5 and 6 are cross-sectional views taken along A-A, B-B, C-C, D-D, and E-E of FIG. 1, respectively, according to one or more embodiments.
FIG. 7 is a diagram illustrating a semiconductor device according to one or more embodiments.
FIGS. 8, 9 and 10 are diagrams illustrating a semiconductor device according to one or more embodiments.
FIG. 11 is a diagram illustrating a semiconductor device according to one or more embodiments.
FIG. 12 is a diagram illustrating a semiconductor device according to one or more embodiments.
FIGS. 13, 14, 15, 16, 17, 18, 19, 20, 21, 22, 23, 24, 25, 26, 27, 28, 29, 30, 31, 32, 33, 34 and 35 are intermediate diagrams illustrating a method for fabricating a semiconductor device according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

A semiconductor device according to one or more embodiments may include a tunneling transistor (tunneling field effect transistor (FET), a three-dimensional (3D) transistor or a transistor based on a two-dimensional material (2D material-based FET), and a heterogeneous structure thereof. Further, the semiconductor device according to one or more embodiments may, of course, include a bipolar junction transistor, a lateral double-diffused transistor (LDMOS), and the like.

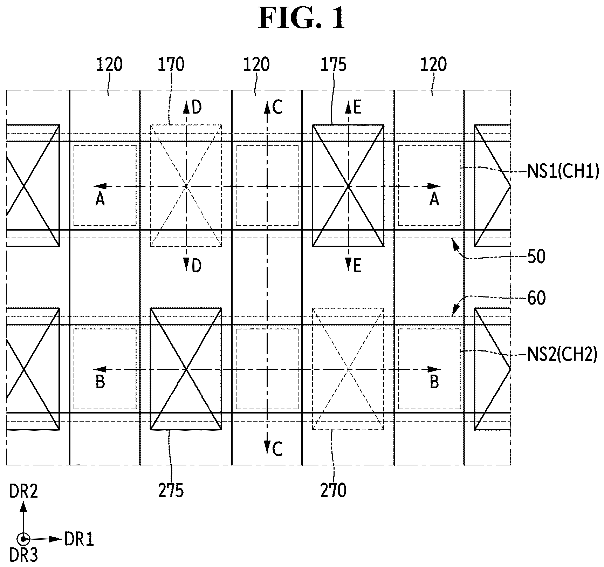

The semiconductor device according to one or more embodiments will be described referring to FIGS. 1 to 6.

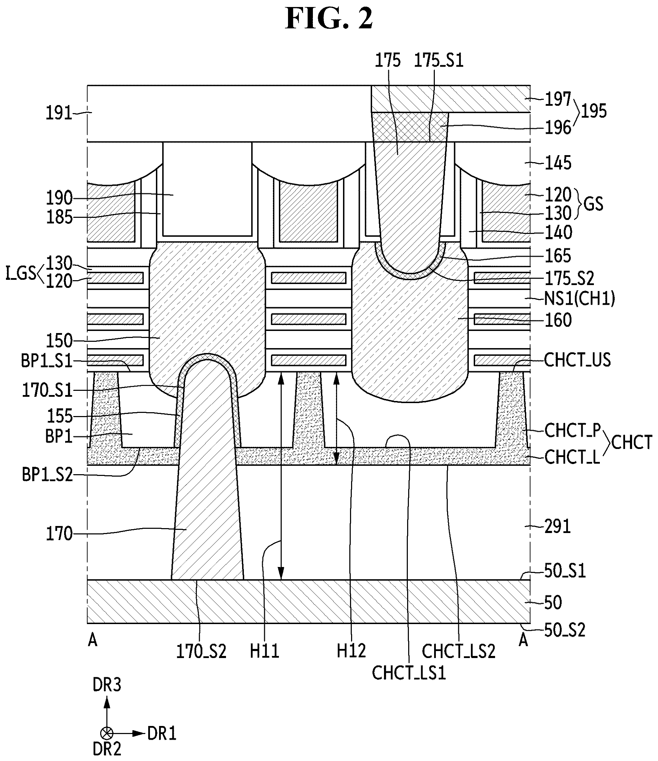

FIG. 1 is a diagram illustrating the semiconductor device according to one or more embodiments. FIGS. 2, 3, 4, 5 and 6 are cross-sectional views taken along A-A, B-B, C-C, D-D, and E-E of FIG. 1, respectively, according to one or more embodiments. For convenience of explanation, a frontside wiring structure 195 is not shown in FIG. 1.

Referring to FIGS. 1 to 6, the semiconductor device according to one or more embodiments may include a first lower pattern BP1, a second lower pattern BP2, a first channel pattern CH1, a second channel pattern CH2, a plurality of gate electrodes 120, a first source/drain pattern 150, a second source/drain pattern 160, a third source/drain pattern 250, a fourth source/drain pattern 260, a first backside source/drain contact 170, a second backside source/drain contact 270, a first frontside source/drain contact 175, a second frontside source/drain contact 275, a first backside wiring line 50, a second backside wiring line 60, a frontside wiring structure 195, and an active region insulating pattern CHCT. In the present application, the term "frontside" may refer to a side of the semiconductor device on which active circuitry, such as transistors, is formed. Conversely, the "backside" may refer to an opposite side to the frontside (e.g., a side which includes a power delivery network). The frontside may be above (e.g., further along the third direction DR3 than) the backside. The terms "frontside" and "backside" do not necessarily limit the semiconductor device to any particular orientation in use.

The first backside wiring line 50 and the second backside wiring line 60 may be disposed inside a backside interlayer insulating film 290. The first backside wiring line 50 and the second backside wiring line 60 may each extend in a first direction DR1. The first backside wiring line 50 may be spaced apart from the second backside wiring line 60 in a second direction DR2.

As an example, the first backside wiring line 50 and the second backside wiring line 60 may be power lines that supply power to the semiconductor device. As another example, the first backside wiring line 50 and the second backside wiring line 60 may be signal lines that supply operation signals to the semiconductor device. As yet another example, one of the first backside wiring line 50 and the second backside wiring line 60 may be a power line and the other may be a signal line.

The first backside wiring line 50 may include a first side 50_S1 and a second side 50_S2 that are opposite to each other in a third direction DR3. The second backside wiring line 60 may include a first side 60_S1 and a second side 60_S2 that are opposite to each other in the third direction DR3. The first side 50_S1 of the first backside wiring line and the first side 60_S1 of the second backside wiring line may face the first channel pattern CH1 and the second channel pattern CH2. Here, the first direction DR1 and the second direction DR2 may be perpendicular to the third direction DR3. Also, the first direction DR1 may be perpendicular to the second direction DR2. The third direction DR3 may define a height direction for the semiconductor device. Elements that are located further along the third direction DR3 than other elements may be considered "above" those other elements. Similarly, an upper surface of an element may be above (e.g., further along the third direction DR3) a lower surface of the element. It will be appreciated that the directions and positions defined herein are defined relative to the structure of the semiconductor device, and therefore do not necessarily limit the semiconductor device to any particular orientation in use.

The first backside wiring line 50 and the second backside wiring line 60 are shown to have a trapezoidal cross section, but embodiments are not limited thereto. The first backside wiring line 50 and the second backside wiring line 60 may have a differently shaped cross-section, such as a rectangular cross section. Taking the first backside wiring line 50 as an example, a width of the first side 50_S1 of the first backside wiring line in the second direction DR2 may be smaller than a width of the second side 50_S2 of the first backside wiring line in the second direction DR2.

For example, the first backside wiring line 50 and the second backside wiring line 60 may be formed using a damascene process. After a trench extending in the first direction DR1 is formed inside the backside interlayer insulating film 290, the first backside wiring line 50 may be formed by filling the trench with a conductive material.

The first backside wiring line 50 and the second backside wiring line 60 are shown to have a single conductive film structure, but embodiments are not limited thereto. The first backside wiring line 50 and the second backside wiring line 60 may have multiple conductive film structures including a backside wiring barrier film and a backside wiring filling film. In such a case, the backside wiring filling film may fill a wiring filling film trench defined by the backside wiring barrier film.

The first backside wiring line 50 and the second backside wiring line 60 may include, for example, at least one of metal, conductive metal nitride, conductive metal carbide, conductive metal oxide, conductive metal oxynitrtide, conductive metal carbonitride or a 2D material. The 2D material may include a 2D allotrope or a 2D compound, and may include, for example, but not limited to, at least one of graphene, boron nitride (BN), molybdenum sulfide, molybdenum selenide, tungsten sulfide, tungsten selenide, and tantalum sulfide. That is, since the above-mentioned 2D materials are only listed by way of example, the 2D materials that may be included in the semiconductor device of the present disclosure are not limited by the above-mentioned materials.

Each of the first backside wiring line 50 and the second backside wiring line 60 may extend in the second direction DR2. In such cases, the shape of the cross-sectional views taken along A-A, B-B, C-C and D-D of FIG. 1 may vary.

Each of the first backside wiring line 50 and the second backside wiring line 60 may include a line portion and a via portion. Taking the first backside wiring line 50 as an example, the line portion of the first backside wiring line 50 may extend (e.g., extend long) in the first direction DR1. The via portion of the first backside wiring line 50 may protrude from the line portion of the first backside wiring line 50 in the third direction DR3. The via portion of the first backside wiring line 50 may protrude toward the first backside source/drain contact 170.

The backside interlayer insulating film 290 may include, for example, at least one of silicon oxide, silicon nitride, silicon oxycarbide, silicon oxynitride or a low dielectric constant material. The dielectric constant of the low dielectric constant material may have a value smaller than 3.9, which is the dielectric constant of silicon oxide. Although the backside interlayer insulating film 290 is shown as being a single film, this is for convenience of explanation and embodiments are not limited thereto.

A backside insertion insulating film 291 may be disposed on the backside interlayer insulating film 290. The backside insertion insulating film 291 may be disposed on the first side 50_S1 of the first backside wiring line 50 and the first side 60_S1 of the second backside wiring line 60.

The backside insertion insulating film 291 may be disposed between the first backside wiring line 50 and the first source/drain pattern 150, and between the first backside wiring line 50 and the second source/drain pattern 160. The backside insertion insulating film 291 may be disposed between the second backside wiring line 60 and the third source/drain pattern 250, and between the second backside wiring line 60 and the fourth source/drain pattern 260. The backside insertion insulating film 291 may have a linear shape extending in the first direction DR1.

The backside insertion insulating film 291 may include, for example, at least one of silicon nitride, silicon oxynitride, silicon oxide, silicon oxycarbonitride, silicon boronitride, silicon oxyboronitride, silicon carbonitride, silicon oxycarbide or a low dielectric constant material.

The first lower patterns BP1 may be disposed on the first side 50_S1 of the first backside wiring line 50. For example, the first lower patterns BP1 may be disposed on the backside insertion insulating film 291. The first lower patterns BP1 may be disposed along the first direction DR1. Each of the first lower patterns BP1 may be spaced apart in the first direction DR1.

The first lower patterns BP1 may be disposed between the first backside wiring line 50 and the first source/drain pattern 150, and between the first backside wiring line 50 and the second source/drain pattern 160. More specifically, the first lower patterns BP1 may be disposed between the backside insertion insulating film 291 and the first source/drain pattern 150, and between the backside insertion insulating film 291 and the second source/drain pattern 160.

The second lower patterns BP2 may be disposed on the first side 60_S1 of the second backside wiring line 60. For example, the second lower patterns BP2 may be disposed on the backside insertion insulating film 291. The second lower patterns BP2 may be disposed along the first direction DR1. Each of the second lower patterns BP2 may be spaced apart in the first direction DR1. The first lower patterns BP1 may be spaced apart from the second lower patterns BP2 in the second direction DR2.

The second lower patterns BP2 may be disposed between the second backside wiring line 60 and the third source/drain pattern 250, and between the second backside wiring line 60 and the fourth source/drain pattern 260. More specifically, the second lower patterns BP2 may be disposed between the backside insertion insulating film 291 and the third source/drain pattern 250, and between the backside insertion insulating film 291 and the fourth source/drain pattern 260.

The first lower pattern BP1 may include a first side BP1_S1 and a second side BP1_S2 that are opposite to each other in the third direction DR3. The second side BP1_S2 of the first lower pattern BP1 may face the first backside wiring line 50.

The second lower pattern BP2 may include a first side BP2_S1 and a second side BP2_S2 that are opposite to each other in the third direction DR3. The second side BP2_S2 of the second lower pattern BP2 may face the second backside wiring line 60.

Each of the first lower pattern BP1 and the second lower pattern BP2 may include, for example, silicon or germanium, which are elemental semiconductor materials. Further, each of the first lower pattern BP1 and the second lower pattern BP2 may include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge) and tin (Sn), or a compound obtained by doping these elements with a group IV element.

The group III-V compound semiconductor may be, for example, at least one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

The field insulating film 105 may be disposed on the first backside wiring line 50 and the second backside wiring line 60. For example, the field insulating film 105 may be disposed on the first side 50_S1 of the first backside wiring line 50 and the first side 60_S1 of the second backside wiring line 60.

The field insulating film 105 may be disposed on the side wall of the first lower pattern BP1. The field insulating film 105 may be disposed on the side wall of the second lower pattern BP2.

The field insulating film 105 may include, for example, at least one of silicon oxide, silicon nitride, silicon oxynitride, and a low dielectric constant material. Although the field insulating film 105 is shown as being a single film, this is only for convenience of explanation, and embodiments are not limited thereto.

The first channel pattern CH1 and the second channel pattern CH2 may be disposed on the first side 50_S1 of the first backside wiring line 50 and the first side 60_S1 of the second backside wiring line 60. The first side 50_S1 of the first backside wiring line 50 and the first side 60_S1 of the second backside wiring line 60 may face the first channel pattern CH1 and the second channel pattern CH2.

The first channel pattern CH1 may be disposed on the first side BP1_S1 of the first lower pattern BP1. The first channel pattern CH1 may be spaced apart from the first lower pattern BP1 in the third direction DR3. The second channel pattern CH2 may be disposed on the first side BP2_S1 of the second lower pattern BP2. The second channel pattern CH2 may be spaced apart from the second lower pattern BP2 in the third direction DR3.

The first channel pattern CH1 and the second channel pattern CH2 may be disposed to be spaced apart in the second direction DR2. The first channel pattern CH1 and the second channel pattern CH2 may be adjacent to each other in the second direction DR2. As an example, the first channel pattern CH1 and the second channel pattern CH2 may be disposed in a region in which transistors of the same conductivity type are formed. As another example, the first channel pattern CH1 and the second channel pattern CH2 may be disposed in a region in which transistors of different conductivity types are formed. That is, the first channel pattern CH1 and the second channel pattern CH2 may have the same conductivity type or different conductivity types. Hereinafter, it will be described that the first channel pattern CH1 is disposed in a region in which p-type transistors are formed (e.g., the first channel pattern CH1 has a p conductivity type), and the second channel pattern CH2 is disposed in a region in which n-type transistors are formed (e.g., the second channel pattern CH2 has an n conductivity type).

Each of the first channel pattern CH1 and the second channel pattern CH2 may be a multi-channel active pattern. For example, the first channel pattern CH1 may include a plurality of first sheet patterns NS1, and the second channel pattern CH2 may include a plurality of second sheet patterns NS2. Each of the first and second channel patterns CH1 and CH2 may be active patterns including nanosheets and/or nanowires. A nanosheet may be a pattern that has a thickness (e.g., in the third direction DR3) that is in the range of 1-100nm. A nanowire may be a pattern that has a thickness (e.g., in the third direction DR3) and width (e.g., in the second direction DR2) that are in the range of 1-100nm.

The plurality of first sheet patterns NS1 may be disposed on the first lower pattern BP1. The plurality of first sheet patterns NS1 may be spaced apart from the first lower pattern BP1 in the third direction DR3. The first sheet pattern NS1 may include an upper side and a bottom side that are opposite to each other in the third direction DR3. The bottom side of the first sheet pattern NS1 may face the first lower pattern BP1. The first sheet pattern NS1 may include a first end and a second end. The first end of the first sheet pattern NS1 may be spaced apart from the second end of the first sheet pattern NS1 in the first direction DR1. Each of the first end of the first sheet pattern NS1 and the second end of the first sheet pattern NS1 may be portions connected to the first and second source/drain patterns 150 and 160 which will be described below.

A plurality of second sheet patterns NS2 may be disposed on the second lower pattern BP2. The plurality of second sheet patterns NS2 may be spaced apart from the second lower pattern BP2 in the third direction DR3. The second sheet pattern NS2 may include an upper side and a bottom side that are opposite to each other in the third direction DR3. The bottom side of the second sheet pattern NS2 may face the second lower pattern BP2. The second sheet pattern NS2 may include a first end and a second end. The first end of the second sheet pattern NS2 may be spaced apart from the second end of the second sheet pattern NS2 in the first direction DR1. Each of the first end of the second sheet pattern NS2 and the second end of the second sheet pattern NS2 may be portions connected to third and fourth source/drain patterns 250 and 260 which will be described below.

Although three first sheet patterns NS1 and three second sheet patterns NS2 are each shown as being disposed in the third direction DR3, this is only for convenience of explanation, and embodiments are not limited thereto. For instance, the first sheet patterns NS1 and the second sheet patterns NS2 may comprise any number of sheet patterns stacked in the third direction DR3.

Each of the first sheet pattern NS1 and the second sheet pattern NS2 may include one of silicon or germanium which is an elemental semiconductor material, a group IV-IV compound semiconductor or a group III-V compound semiconductor. Each first sheet pattern NS1 may include the same material as the first lower pattern BP1, or may include a different material from the first lower pattern BP1. Each second sheet pattern NS2 may include the same material as the second lower pattern BP2, or may include a different material from the second lower pattern BP2.

In the semiconductor device according to one or more embodiments, each of the first lower pattern BP1 and the second lower pattern BP2 may be a silicon lower pattern including silicon, and each of the first sheet pattern NS1 and the second sheet pattern NS2 may be a silicon sheet pattern including silicon.

Although widths of each first sheet patterns NS1 are shown as being the same, embodiments are not limited thereto. Although widths of each second sheet pattern NS2 are shown as being the same, embodiments are not limited thereto. For instance, the widths of the first sheet patterns NS1 and second sheet patterns NS2 may change (e.g., may increase or decrease) in the third direction DR3.

A plurality of gate structures GS may be disposed on the first side 50_S1 of the first backside wiring line 50 and the first side 60_S1 of the second backside wiring line 60. The plurality of gate structures GS may be disposed on the field insulating film 105.

The first lower pattern BP1 may be disposed between the gate structure GS and the first backside wiring line 50. The second lower pattern BP2 may be disposed between the gate structure GS and the second backside wiring line 60. The gate structures GS may be disposed on the first side BP1_S1 of the first lower pattern BP1 and the first side BP2_S1 of the second lower pattern BP2.

Each gate structure GS may extend in the second direction DR2. The gate structures GS may be disposed to be spaced apart in the first direction DR1. The gate structures GS may be adjacent to each other in the first direction DR1.

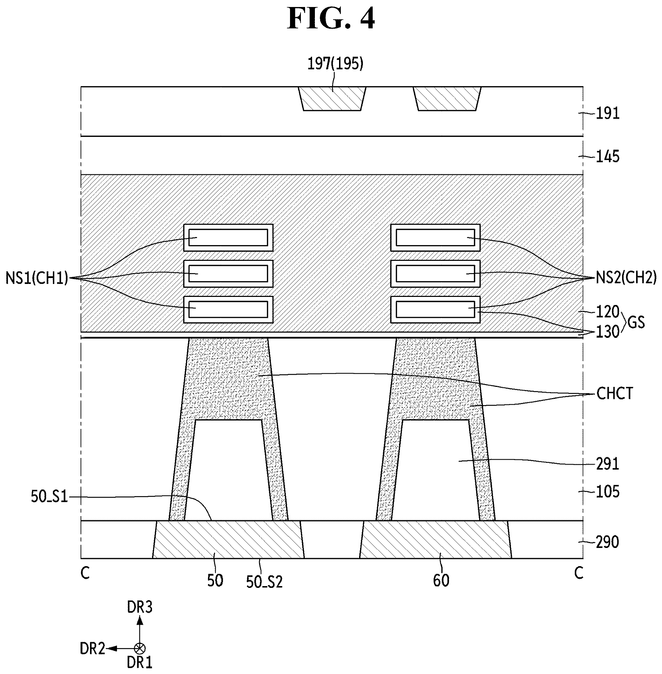

In a cross-sectional view (e.g., extending in the second direction DR2 and third direction DR3) such as FIG. 4, the gate structure GS may enclose the first sheet pattern NS1. Similarly, the gate structure GS may enclose the second sheet pattern NS2.

Although the gate structure GS is shown as being disposed across both the first channel pattern CH1 and the second channel pattern CH2, this is only for convenience of explanation, and embodiments are not limited thereto. That is, a portion of the gate structure GS may be separated into a first portion and a second portion by a gate isolation structure disposed on the field insulating film 105. In this case, the first portion of the gate structure GS may enclose the first sheet pattern NS1, and the second portion of the gate structure GS may enclose the second sheet pattern NS2.

The gate structure GS may include, for example, a gate electrode 120 and a gate insulating film 130.

In the semiconductor device according to one or more embodiments, the gate structure GS may include a plurality of inner gate structures I_GS disposed between the first lower pattern BP1 and the first sheet pattern NS1, and between the first sheet patterns NS1 adjacent to each other in the third direction DR3. An inner gate structure I_GS may be disposed between the second sheet patterns NS2 adjacent to each other in the third direction DR3.

An inner gate structure I_GS may be disposed between an upper side of the first sheet pattern NS1 and a bottom side of the first sheet pattern NS1 that face each other (e.g., that are adjacent to each other) in the third direction DR3. An inner gate structure I_GS may be disposed between a first side BP1_S1 of the first lower pattern BP1 and a bottom side of the first sheet pattern NS1 (e.g., the lowermost first sheet pattern NS1). An inner gate structure I_GS may be disposed between an upper side of the second sheet pattern NS2 and a bottom side of the second sheet pattern NS2 that face each other (e.g., that are adjacent to each other) in the third direction DR3. An inner gate structure I_GS may be disposed between a first side BP2_S1 of the second lower pattern BP2 and a bottom side of the second sheet pattern NS2 (e.g., the lowermost second sheet pattern NS2). The inner gate structure I_GS may include a gate electrode 120 and a gate insulating film 130.

The inner gate structure I_GS may contact the upper side of the first sheet pattern NS1 and the bottom side of the first sheet pattern NS1 (e.g., that are adjacent to each other in the third direction DR3). The inner gate structure I_GS may contact the upper side of the second sheet pattern NS2 and the bottom side of the second sheet pattern NS2 (e.g., that are adjacent to each other in the third direction DR3). The inner gate structure I_GS may contact the first side BP1_S1 of the first lower pattern BP1 and the first side BP2_S1 of the second lower pattern BP2.

In the semiconductor device according to one or more embodiments, the inner gate structure I_GS may contact first and second source/drain patterns 150 and 160 to be described below. The inner gate structure I_GS may contact third and fourth source/drain patterns 250 and 260 to be described below.

The gate electrode 120 may be disposed on the first lower pattern BP1 and the second lower pattern BP2. The gate electrode 120 may enclose the first sheet pattern NS1 and the second sheet pattern NS2.

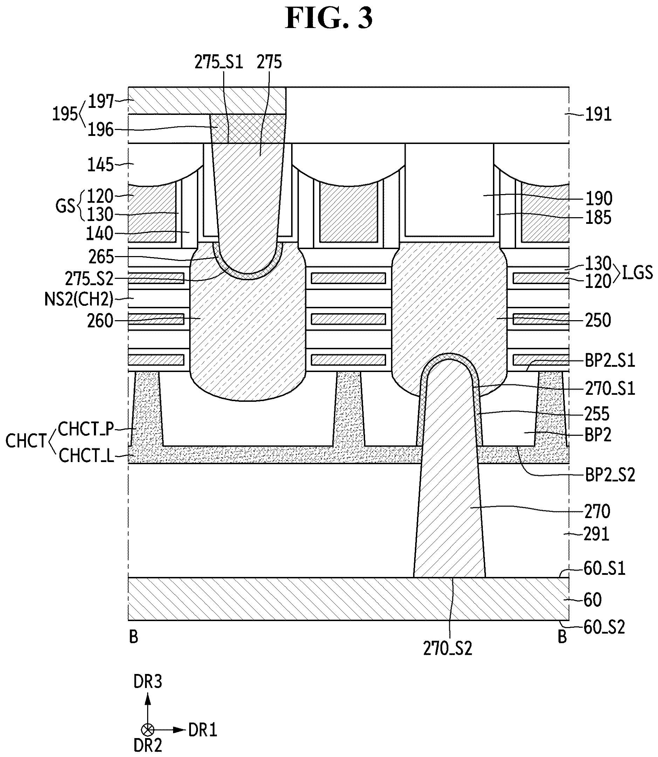

In the cross-sectional views such as FIGS. 2 and 3, although the upper side of the gate electrode 120 is shown as a concave curved face, embodiments are not limited thereto. The upper side of the gate electrode 120 may be flat.

The gate electrode 120 may include at least one of metal, conductive metal nitride, metal silicide, doped semiconductor material, conductive metal oxide, conductive metal oxynitride, conductive metal carbide or conductive metal carbonitride. The gate electrode 120 may include, but is not limited to, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V) or combinations thereof. The conductive metal oxide and the conductive metal oxynitride may include, but are not limited to, an oxidized form of the aforementioned materials.

The gate insulating film 130 may extend along the upper side of the field insulating film 105. The gate insulating film 130 may enclose the first sheet pattern NS1. The gate insulating film 130 may enclose the second sheet pattern NS2. The gate insulating film 130 may be disposed along the periphery of the first sheet pattern NS1 and the periphery of the second sheet pattern NS2. The gate electrode 120 may be disposed on the gate insulating film 130.

The gate insulating film 130 may be disposed between the gate electrode 120 and the first sheet pattern NS1, and between the gate electrode 120 and the second sheet pattern NS2. In the semiconductor device according to one or more embodiments, the gate insulating film 130 included in the inner gate structure I_GS may contact first to fourth source/drain patterns 150, 160, 250 and 260 which will be described below.

The gate insulating film 130 may include silicon oxide, silicon oxynitride, silicon nitride or a high dielectric constant material. In the present application a "high dielectric constant" material may be a material having a dielectric constant that is higher than that of silicon oxide. The high dielectric constant material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the gate insulating film 130 is shown as a single film, this example is only for convenience of explanation and is not limited thereto. The gate insulating film 130 may include a plurality of films. The gate insulating film 130 may include an interfacial layer and a high dielectric constant insulating film which are disposed between the first sheet pattern NS1 and the gate electrode 120, and between the second sheet pattern NS2 and the gate electrode 120. In one example, the interfacial layer may not be formed along the profile (e.g., the surface) of the upper side of the field insulating film 105.

The semiconductor device according to one or more embodiments may include a Negative Capacitance (NC) FET that uses a negative capacitor. For example, the gate insulating film 130 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances may decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide or lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr) or tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al) or yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have paraelectric properties. The paraelectric material film may include at least one of, for example, a silicon oxide or a metal oxide having a high dielectric constant (e.g., a dielectric constant that is higher than that of silicon oxide). The metal oxide included in the paraelectric material film may include, for example, but is not limited to, at least one of hafnium oxide, zirconium oxide or aluminum oxide.

The ferroelectric material film and the paraelectric material film may include the same material. The ferroelectric material film has ferroelectric properties, but the paraelectric material film may not have ferroelectric properties. For example, when the ferroelectric material film and the paraelectric material film include hafnium oxide, a crystal structure of hafnium oxide included in the ferroelectric material film may be different from a crystal structure of hafnium oxide included in the paraelectric material film.

The ferroelectric material film may have a thickness having ferroelectric properties. The thickness of the ferroelectric material film may be, for example, but is not limited to, 0.5 to 10 nm. Since a critical thickness that exhibits ferroelectric properties may vary for each ferroelectric material, the thickness of the ferroelectric material film may vary depending on the ferroelectric material.

As an example, the gate insulating film 130 may include one ferroelectric material film. As another example, the gate insulating film 130 may include a plurality of ferroelectric material films spaced apart from each other. The gate insulating film 130 may have a stacked film structure in which the plurality of ferroelectric material films and the plurality of paraelectric material films are stacked alternately.

The gate spacer 140 may be disposed on the side wall of the gate electrode 120. In the semiconductor device according to one or more embodiments, the gate spacer 140 may not be disposed between the first sheet patterns NS1 adjacent to each other in the third direction DR3. The gate spacer 140 may not be disposed between the second sheet patterns NS2 adjacent to each other in the third direction DR3.

The gate spacer 140 may include, for example, at least one of silicon nitride, silicon oxynitride, silicon oxide, silicon oxycarbonitride, silicon boronitride, silicon oxyboronitride, silicon oxycarbide or a combination thereof. Although the gate spacers 140 are shown as being a single film, this example is only for convenience of explanation and is not limited thereto.

A gate capping pattern 145 may be disposed on the gate electrode 120. An upper side of the gate capping pattern 145 may be coplanar with an upper side of the first frontside interlayer insulating film 190.

The gate capping pattern 145 may be disposed between the gate spacers 140. The gate capping pattern 145 may not be disposed on the upper side of the gate electrode 120.

The gate capping pattern 145 may include, for example, at least one of silicon nitride, silicon oxynitride, silicon carbonitride, silicon oxycarbonitride, and combinations thereof. The gate capping pattern 145 may include a material having an etch selectivity with respect to the first frontside interlayer insulating film 190.

The active region insulating pattern CHCT may be disposed on the first side 50_S1 of the first backside wiring line 50 and the first side 60_S1 of the second backside wiring line 60. The active region insulating pattern CHCT may be disposed between the first channel pattern CH1 and the first backside wiring line 50. The active region insulating pattern CHCT may be disposed between the second channel pattern CH2 and the second backside wiring line 60.

The first lower pattern BP1 may be disposed on the active region insulating pattern CHCT. The first lower pattern BP1 may be disposed between the active region insulating pattern CHCT and the first source/drain pattern 150, and between the active region insulating pattern CHCT and the second source/drain pattern 160.

The second side BP1_S2 of the first lower pattern BP1 may be above a surface of the active region insulating pattern CHCT in the third direction DR3. The active region insulating pattern CHCT may contact the first lower pattern BP1. The active region insulating pattern CHCT may contact the second side BP1_S2 of the first lower pattern BP1.

The second lower pattern BP2 may be disposed on the active region insulating pattern CHCT. The second lower pattern BP2 may be disposed between the active region insulating pattern CHCT and the third source/drain pattern 250, and between the active region insulating pattern CHCT and the fourth source/drain pattern 260.

The second side BP2_S2 of the second lower pattern BP2 may be above a surface of the active region insulating pattern CHCT in the third direction DR3. The active region insulating pattern CHCT may contact the second lower pattern BP2. The active region insulating pattern CHCT may contact the second side BP2_S2 of the second lower pattern BP2.

The active region insulating pattern CHCT may include a line portion CHCT_L and a protruding portion CHCT_P. The line portion CHCT_L of the active region insulating pattern CHCT may extend in the first direction DR1. The protruding portion CHCT_P of the active region insulating pattern CHCT may protrude from the line portion CHCT_L of the active region insulating pattern CHCT in the third direction DR3.

The line portion CHCT_L of the active region insulating pattern CHCT may extend along the second side BP1_S2 of the first lower pattern BP1. The line portion CHCT_L of the active region insulating pattern CHCT may extend along the second side BP2_S2 of the second lower pattern BP2.

The first lower pattern BP1 may be disposed between the line portion CHCT_L of the active region insulating pattern CHCT and the first source/drain pattern 150, and between the line portion CHCT_L of the active region insulating pattern CHCT and the second source/drain pattern 160. The second lower pattern BP2 may be disposed between the line portion CHCT_L of the active region insulating pattern CHCT and the third source/drain pattern 250, and between the line portion CHCT_L of the active region insulating pattern CHCT and the fourth source/drain pattern 260.

In the cross-sectional views such as FIGS. 2 and 3, the line portion CHCT_L of the active region insulating pattern CHCT may include a first side CHCT_LS1 and a second side CHCT_LS2 that are opposite to each other in the third direction DR3. The first side CHCT_LS1 of the line portion CHCT_L of the active region insulating pattern CHCT may contact the first lower pattern BP1 and the second lower pattern BP2.

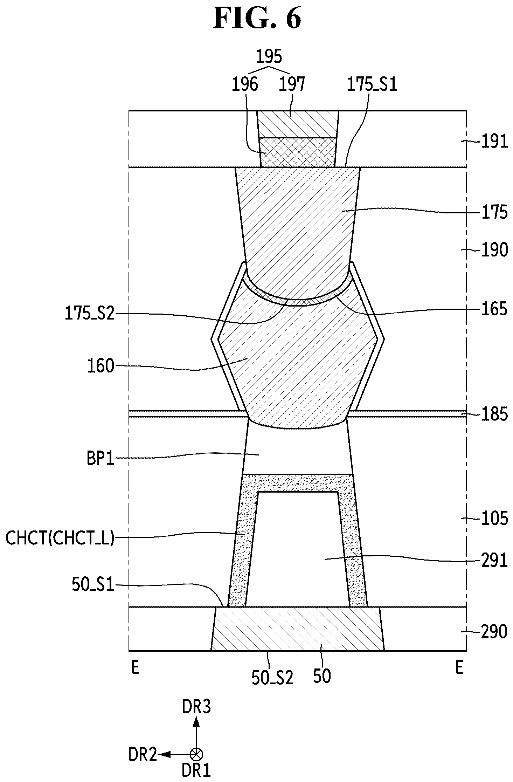

In FIGS. 4 and 6, the active region insulating pattern CHCT may be disposed between the backside insertion insulating film 291 and the field insulating film 105. For example, the line portion CHCT_L of the active region insulating pattern CHCT may be disposed on a side wall of the backside insertion insulating film 291.

If the active region insulating pattern CHCT and the field insulating film 105 include the same material, a boundary between the active region insulating pattern CHCT and the field insulating film 105 may not be distinguished in the cross-sectional view such as FIG. 6. In this case, the boundary between the active region insulating pattern CHCT and the field insulating film 105 may be distinguished using an extension line of the side wall of the first lower pattern BP1.

If the active region insulating pattern CHCT and the backside insertion insulating film 291 include the same material, the boundary between the active region insulating pattern CHCT and the backside insertion insulating film 291 may not be distinguished.

The protruding portion CHCT_P of the active region insulating pattern CHCT may protrude from the line portion CHCT_L of the active region insulating pattern CHCT toward the first sheet pattern NS1. The protruding portion CHCT_P of the active region insulating pattern CHCT protrude may from the line portion CHCT_L of the active region insulating pattern CHCT toward the second sheet pattern NS2. The protruding portion CHCT_P of the active region insulating pattern CHCT may protrude from the first side CHCT_LS1 of the line portion CHCT_L of the active region insulating pattern CHCT in the third direction DR3.

The protruding portion CHCT_P of the active region insulating pattern CHCT may be disposed between the first lower patterns BP1 adjacent to each other in the first direction DR1. The protruding portion CHCT_P of the active region insulating pattern CHCT may separate the first lower patterns BP1. The protruding portion CHCT_P of the active region insulating pattern CHCT may extend up to the first side BP1_S1 of the first lower pattern BP1.

The protruding portion CHCT_P of the active region insulating pattern CHCT may be disposed between the second lower patterns BP2 adjacent to each other in the first direction DR1. The protruding portion CHCT_P of the active region insulating pattern CHCT may separate the second lower pattern BP2. The protruding portion CHCT_P of the active region insulating pattern CHCT may extend up to the first side BP2_S1 of the second lower pattern BP2.

The protruding portion CHCT_P of the active region insulating pattern CHCT may contact the gate structure GS. The protruding portion CHCT_P of the active region insulating pattern CHCT may contact the inner gate structure I_GS (e.g., the lowermost inner gate structure I_GS) disposed between the first lower pattern BP1 and the first sheet pattern NS1 (e.g., the lowermost first sheet pattern NS1). The protruding portion CHCT_P of the active region insulating pattern CHCT may contact the inner gate structure I_GS (e.g., the lowermost inner gate structure I_GS) disposed between the second lower pattern BP2 and the second sheet pattern NS2 (e.g., the lowermost second sheet pattern NS2).

An upper side CHCT_US of the protruding portion CHCT_P of the active region insulating pattern CHCT may be the uppermost side of the active region insulating pattern CHCT. The upper side CHCT_US of the protruding portion CHCT_P of the active region insulating pattern CHCT may contact the inner gate structure I_GS.

The active region insulating pattern CHCT may include an insulating material. The active region insulating pattern CHCT may include at least one of, for example, silicon nitride, silicon oxynitride, silicon oxide, silicon oxycarbonitride, silicon boronitride, silicon oxyboronitride, silicon carbonitride or silicon oxycarbide.

The first source/drain pattern 150 and the second source/drain pattern 160 may be disposed on the first side 50_S1 of the first backside wiring line 50. The second source/drain pattern 160 may be spaced apart from the first source/drain pattern 150 in the first direction DR1.

The first source/drain pattern 150 and the second source/drain pattern 160 may be connected to the first channel pattern CH1. The first source/drain pattern 150 and the second source/drain pattern 160 may contact the first sheet pattern NS1. The first source/drain pattern 150 may be connected to a first end of the first sheet pattern NS1. The second source/drain pattern 160 may be connected to a second end of the first sheet pattern NS1.

The first channel pattern CH1 may be disposed between the first source/drain pattern 150 and the second source/drain pattern 160. The gate electrode 120 may be disposed between the first source/drain pattern 150 and the second source/drain pattern 160.

Each of the first source/drain pattern 150 and the second source/drain pattern 160 may be disposed on the first lower pattern BP1. Each of the first source/drain pattern 150 and the second source/drain pattern 160 may be above the first lower pattern BP1 in the third direction DR3. For example, each of the first source/drain pattern 150 and the second source/drain pattern 160 may contact the first lower pattern BP1.

The third source/drain pattern 250 and the fourth source/drain pattern 260 may be disposed on the first side 60_S1 of the second backside wiring line 60. The fourth source/drain pattern 260 may be spaced apart from the third source/drain pattern 250 in the first direction DR1.

The third source/drain pattern 250 and the fourth source/drain pattern 260 may be connected to the second channel pattern CH2. The third source/drain pattern 250 and the fourth source/drain pattern 260 may contact the second sheet pattern NS2. The third source/drain pattern 250 may be connected to the first end of the second sheet pattern NS2. The fourth source/drain pattern 260 may be connected to the second end of the second sheet pattern NS2. The second channel pattern CH2 may be disposed between the third source/drain pattern 250 and the fourth source/drain pattern 260.

Each of the third source/drain pattern 250 and the fourth source/drain pattern 260 may be disposed on the second lower pattern BP2. Each of the third source/drain pattern 250 and the fourth source/drain pattern 260 may be above the second lower pattern BP2 in the third direction DR3. Each of the third source/drain pattern 250 and the fourth source/drain pattern 260 may contact the second lower pattern BP2.

The first source/drain pattern 150 and the second source/drain pattern 160 may be included in the source/drain of a transistor that uses the first channel pattern CH1 as a channel region. For instance, the first source/drain pattern 150 may be one of a source or drain of the transistor, and the second source/drain pattern 160 may the other of the source or drain of the transistor. The third source/drain pattern 250 and the fourth source/drain pattern 260 may be included in the source/drain of a transistor that uses the second channel pattern CH2 as a channel region. For instance, the third source/drain pattern 250 may be one of a source or drain of the transistor, and the fourth source/drain pattern 260 may the other of the source or drain of the transistor.

Each of the first to fourth source/drain patterns 150, 160, 250, and 260 may include an epitaxial pattern. Each of the first to fourth source/drain patterns 150, 160, 250, and 260 may include a semiconductor material.

The first to fourth source/drain patterns 150, 160, 250, and 260 may include, for example, silicon or germanium which is an elemental semiconductor material. Also, the first to fourth source/drain patterns 150, 160, 250, and 260 may include, for example, a binary compound or a ternary compound including at least two or more of carbon (C), silicon (Si), germanium (Ge), and tin (Sn), or a compound obtained by doping these elements with a group IV element. For example, the first to fourth source/drain patterns 150, 160, 250, and 260 may include, but are not limited to, silicon, silicon-germanium, silicon carbide, and the like.

The first source/drain pattern 150 and the second source/drain pattern 160 may include p-type impurities. The p-type impurities may include, but are not limited to, at least one of boron (B) or gallium (Ga).

Each of the third source/drain pattern 250 and the fourth source/drain pattern 260 may include silicon. The third source/drain pattern 250 and the fourth source/drain pattern 260 may include, but are not limited to, n-type impurities. The n-type impurities may include, but are not limited to, at least one of phosphorus (P), arsenic (As), antimony (Sb), or bismuth (Bi).

The first to fourth source/drain patterns 150, 160, 250, 260 are shown as being single films, but embodiments are not limited thereto.

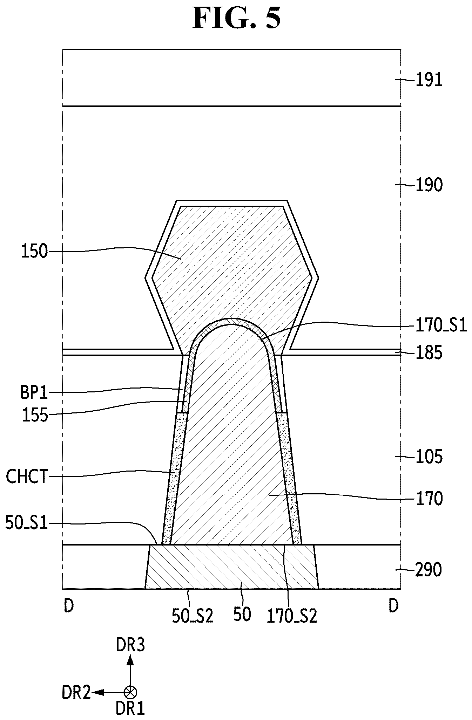

In FIGS. 5 and 6, although each of an external shape of the first source/drain pattern 150 and an external shape of the second source/drain pattern 160 is shown to be generally hexagonal (e.g., a shape similar to a hexagon), embodiments are not limited thereto. The external shape of the first source/drain pattern 150 and the external shape of the second source/drain pattern 160 may be generally pentagonal or square (e.g., a shape similar to a pentagon or a square).

The active region insulating pattern CHCT may not contact the first source/drain pattern 150 and the second source/drain pattern 160. The protruding portion CHCT_P of the active region insulating pattern CHCT may be disposed between the first source/drain pattern 150 and the second source/drain pattern 160. The active region insulating pattern CHCT may not contact the third source/drain pattern 250 and the fourth source/drain pattern 260. The protruding portion CHCT_P of the active region insulating pattern CHCT may be disposed between the third source/drain pattern 250 and the fourth source/drain pattern 260.

The first frontside interlayer insulating film 190 may be disposed on the field insulating film 105. The first frontside interlayer insulating film 190 may be disposed on the first to fourth source/drain patterns 150, 160, 250, and 260. The first frontside interlayer insulating film 190 may not cover the upper side of the gate capping pattern 145. For example, the upper side of the first frontside interlayer insulating film 190 may be coplanar with the upper side of the gate capping pattern 145.

The first frontside interlayer insulating film 190 may be disposed on the first side 50_S1 of the first backside wiring line 50 and the first side 60_S1 of the second backside wiring line 60. The first frontside interlayer insulating film 190 may include, for example, at least one of silicon oxide, silicon nitride, silicon oxynitride, and a low dielectric constant material.

A source/drain etch stop film 185 may extend along the profile (e.g., the surface) of the first source/drain pattern 150, the profile (e.g., the surface) of the second source/drain pattern 160, the profile (e.g., the surface) of the third source/drain pattern 250, and the profile (e.g., the surface) of the fourth source/drain pattern 260. The first frontside interlayer insulating film190 may be disposed on the source/drain etch stop film 185.

The source/drain etch stop film 185 may include, for example, at least one of silicon nitride, silicon oxynitride, silicon oxycarbonitride, silicon boronitride, silicon oxyboronitride, silicon oxycarbide or combinations thereof.

The first backside source/drain contact 170 may extend lengthwise in the third direction DR3. The first backside source/drain contact 170 may be connected to the first source/drain pattern 150. For example, the first backside source/drain contact 170 may be electrically connected to the first source/drain pattern 150.

The first backside source/drain contact 170 may be disposed between the first source/drain pattern 150 and the first backside wiring line 50. The first backside source/drain contact 170 may be between the first backside wiring line 50 and the first source/drain pattern 150 in the third direction DR3.

The first backside source/drain contact 170 may be connected to the first backside wiring line 50. For example, the first backside source/drain contact 170 may connect the first source/drain pattern 150 and the first backside wiring line 50. The first backside source/drain contact 170 may be connected to the first side 50_S1 of the first backside wiring line 50. The first backside source/drain contact 170 may extend from the first side 50_S1 of the first backside wiring line 50 to the first source/drain pattern 150.

The first backside source/drain contact 170 may extend through the active region insulating pattern CHCT. For example, the first backside source/drain contact 170 may extend through the line portion CHCT_L of the active region insulating pattern CHCT.

The first backside source/drain contact 170 may be disposed between the protruding portions CHCT_P of the active region insulating patterns CHCT adjacent to each other in the first direction DR1. The first backside source/drain contact 170 may not contact the protruding portion CHCT_P of the active region insulating pattern CHCT. The first backside source/drain contact 170 may be spaced apart from the protruding portion CHCT_P of the active region insulating pattern CHCT in the first direction DR1.

The first backside source/drain contact 170 may include a first side 170_S1 and a second side 170_S2. The first side 170_S1 of the first backside source/drain contact 170 may face the first source/drain pattern 150. The first side 170_S1 of the first backside source/drain contact 170 may be connected to the first source/drain pattern 150. For example, the first side 170_S1 of the first backside source/drain contact 170 may be an interface between the first backside source/drain contact 170 and a first backside contact silicide film 155. The first side 170_S1 of the first backside source/drain contact 170 may be a connecting side that contacts the backside contact silicide film 155. The first side 170_S1 of the first backside source/drain contact 170 may be a connecting side that connects the first backside source/drain contact 170 and the first source/drain pattern 150.

The second side 170_S2 of the first backside source/drain contact 170 may face the first backside wiring line 50. The second side 170_S2 of the first backside source/drain contact 170 may be connected to the first backside wiring line 50.

The first backside contact silicide film 155 may be disposed between the first backside source/drain contact 170 and the first source/drain pattern 150. The first backside contact silicide film 155 may contact the first source/drain pattern 150.

The first backside source/drain contact 170 may pass through the first lower pattern BP1 and be connected to the first source/drain pattern 150. A portion of the first backside source/drain contact 170 may be disposed inside the first lower pattern BP1.

In the cross-sectional view such as FIG. 2, a portion of the first backside source/drain contact 170 may protrude toward the first backside wiring line 50 beyond the second side CHCT_LS2 of the line portion CHCT_L of the active region insulating pattern CHCT. A distance H11 from the first side BP1_S1 of the first lower pattern BP1 to the first side 50_S1 of the first backside wiring line 50 is greater than a distance H12 from the first side BP1_S1 of the first lower pattern BP1 to the second side CHCT_LS2 of the line portion CHCT_L of the active region insulating pattern CHCT.

The second backside source/drain contact 270 may extend lengthwise in the third direction DR3. The second backside source/drain contact 270 may be electrically connected to the third source/drain pattern 250.

The second backside source/drain contact 270 may be disposed between the third source/drain pattern 250 and the second backside wiring line 60. The second backside source/drain contact 270 may be between the second backside wiring line 60 and the third source/drain pattern 250 in the third direction DR3. The second backside source/drain contact 270 may connect the third source/drain pattern 250 and the second backside wiring line 60.

The second backside source/drain contact 270 may extend through the active region insulating pattern CHCT. The second backside source/drain contact 270 may be disposed between the protruding portions CHCT_P of the active region insulating patterns CHCT adjacent to each other in the first direction DR1.

The second backside source/drain contact 270 may include a first side 270_S1 and a second side 270_S2. The first side 270_S1 of the second backside source/drain contact 270 may be connected to the third source/drain pattern 250. The first side 270_S1 of the second backside source/drain contact 270 may be a connecting side that connects the second backside source/drain contact 270 and the third source/drain pattern 250. The second side 270_S2 of the second backside source/drain contact 270 may be connected to the second backside wiring line 60.

A second backside contact silicide film 255 may be disposed between the second backside source/drain contact 270 and the third source/drain pattern 250. The first side 270_S1 of the second backside source/drain contact 270 may be an interface between the second backside source/drain contact 270 and the second backside contact silicide film 255.

Each of the first backside source/drain contact 170 and the second backside source/drain contact 270 may include a conductive material. Each of the first backside source/drain contact 170 and the second backside source/drain contact 270 may include at least one of, for example, a metal, a conductive metal nitride, a conductive metal carbide, a conductive metal oxide, a conductive metal oxynitride, a conductive metal silicon nitride, a conductive metal carbonitride or a two-dimensional material. Although each of the first backside source/drain contact 170 and the second backside source/drain contact 270 is shown as being a single film, this is only for convenience of explanation, and embodiments are not limited thereto. Each of the first backside source/drain contact 170 and the second backside source/drain contact 270 may have a multiple conductive film structure. Each of the first backside source/drain contact 170 and the second backside source/drain contact 270 may include a backside contact barrier film and a backside contact filling film.

Each of the first backside contact silicide film 155 and the second backside contact silicide film 255 may include a metal silicide material.

The first frontside source/drain contact 175 may extend lengthwise in the third direction DR3. The first frontside source/drain contact 175 may be connected to the second source/drain pattern 160. For example, the first frontside source/drain contact 175 is electrically connected to the second source/drain pattern 160.

The first frontside source/drain contact 175 may be disposed inside the first frontside interlayer insulating film 190 and the second source/drain pattern 160. A portion of the first frontside source/drain contact 175 may be disposed inside the second source/drain pattern 160.

The first frontside source/drain contact 175 may include a first side 175_S1 and a second side 175_S2 that are opposite to each other in the third direction DR3. The second side 175_S2 of the first frontside source/drain contact 175 may face the second source/drain pattern 160. The second side 175_S2 of the first frontside source/drain contact 175 may be connected to the second source/drain pattern 160. For example, the second side 175_S2 of the first frontside source/drain contact 175 may be an interface between the first frontside source/drain contact 175 and a first frontside contact silicide film 165.

The second frontside source/drain contact 275 may extend lengthwise in the third direction DR3. The second frontside source/drain contact 275 may be electrically connected to the fourth source/drain pattern 260. The second frontside source/drain contact 275 may be disposed inside the first frontside interlayer insulating film 190 and the fourth source/drain pattern 260.

The second frontside source/drain contact 275 may include a first side 275_S1 and a second side 275_S2 that are opposite to each other in the third direction DR3. The second side 275_S2 of the second frontside source/drain contact 275 may be connected to the fourth source/drain pattern 260.

Although the first frontside source/drain contact 175 and the second frontside source/drain contact 275 are shown to have a single conductive film structure, embodiments are not limited thereto. The first frontside source/drain contact 175 and the second frontside source/drain contact 275 may include at least one of, for example, a metal, a conductive metal nitride, a conductive metal carbide, a conductive metal oxide, a conductive metal carbonitride or a two-dimensional material.

The first frontside contact silicide film 165 may be disposed between the first frontside source/drain contact 175 and the second source/drain pattern 160. The second frontside contact silicide film 265 may be disposed between the second frontside source/drain contact 275 and the fourth source/drain pattern 260. The first frontside contact silicide film 165 and the second frontside contact silicide film 265 may include a metal silicide material.

A second frontside interlayer insulating film 191 may be disposed on the first frontside interlayer insulating film 190, the gate structure GS, the second frontside source/drain contact 175, and the second frontside source/drain contact 275. The second frontside interlayer insulating film 191 may include, for example, at least one of silicon oxide, silicon nitride, silicon carbonitride, silicon oxynitride, and a low dielectric constant material.

The frontside wiring structure 195 may be disposed inside the second frontside interlayer insulating film 191. The frontside wiring structure 195 may be disposed on the first side 50_S1 of the first backside wiring line 50 and the first side 60_S1 of the second backside wiring line 60. The frontside wiring structure 195 may include a frontside via plug 196 and a frontside wiring line 197.

The frontside wiring structure 195 may be connected to the first frontside source/drain contact 175 and the second frontside source/drain contact 275. The frontside wiring structure 195 may be connected to the first side 175_S1 of the first frontside source/drain contact 175 and the first side 275_S1 of the second frontside source/drain contact 275. For example, the frontside wiring structure 195 may not be connected to the first source/drain pattern 150 connected to the first backside source/drain contact 170, and may not be connected to the third source/drain pattern 250 connected to the second backside source/drain contact 270.

The frontside wiring structure 195 may be connected to the first source/drain pattern 150 through another frontside source/drain contact. For instance, the frontside wiring structure 195 may be connected to the first backside source/drain contact 170 via the first source/drain pattern 150.

Each of the frontside via plug 196 and the frontside wiring line 197 may include at least one of, for example, metal, conductive metal nitride, conductive metal carbide, conductive metal oxide, conductive metal carbonitride or a two-dimensional material.

Although each of the frontside via plug 196 and the frontside wiring line 197 is shown as being a single conductive film structure, this example is only for convenience of explanation and embodiments are not limited thereto. At least one of the frontside via plug 196 or the frontside wiring line 197 may have multiple conductive film structures, as an example. As another example, the frontside wiring structure 195 may have an integral structure with no boundary division between the frontside via plug 196 and the frontside wiring line 197.

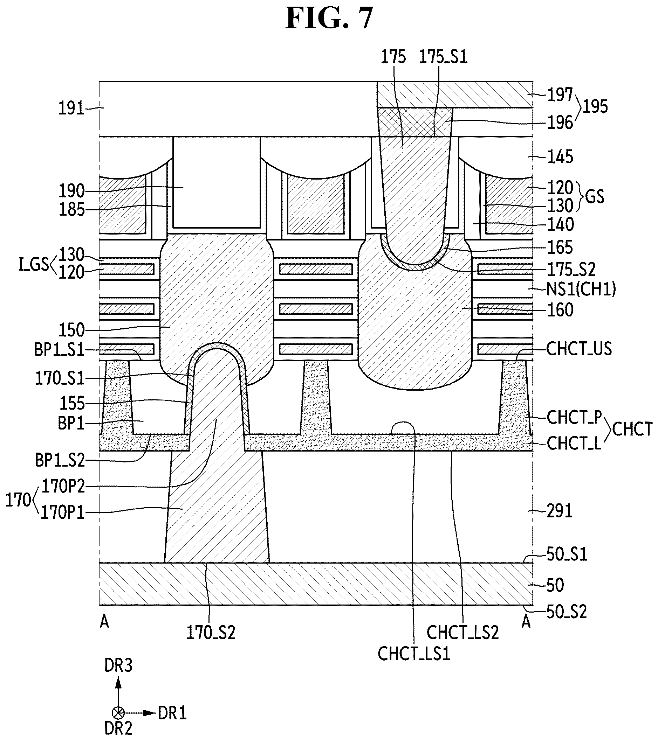

FIG. 7 is a diagram illustrating a semiconductor device according to one or more embodiments. For convenience of explanation, differences from those described using FIGS. 1 to 6 will be mainly described.

Referring to FIG. 7, in the semiconductor device according to one or more embodiments, the first backside source/drain contact 170 may include a first portion 170P1 and a second portion 170P2.

The second portion 170P2 of the first backside source/drain contact 170 may be disposed on the first portion 170P1 of the first backside source/drain contact 170. The second portion 170P2 of the first backside source/drain contact 170 may be disposed between the first portion 170P1 of the first backside source/drain contact 170 and the first source/drain pattern 150.

The first portion 170P1 of the first backside source/drain contact 170 may be a portion by which the first backside source/drain contact 170 is connected to the first backside wiring line 50. The second portion 170P2 of the first backside source/drain contact 170 may be a portion by which the first backside source/drain contact 170 is connected to the first source/drain pattern 150.

For example, in terms of a cross-sectional view, the first portion 170P1 of the first backside source/drain contact 170 may be disposed inside the backside insertion insulating film 291. In terms of the cross-sectional view, the second portion 170P2 of the first backside source/drain contact 170 may be disposed inside the active region insulating pattern CHCT and the first lower pattern BP1.

A boundary between the first portion 170P1 of the first backside source/drain contact 170 and the second portion 170P2 of the first backside source/drain contact 170 may be, for example, the second side CHCT_LS2 of the line portion CHCT_L of the active region insulating pattern CHCT. At the boundary between the first portion 170P1 of the first backside source/drain contact 170 and the second portion 170P2 of the first backside source/drain contact 170, a width (e.g., in the first direction DR1) of the first portion 170P1 of the first backside source/drain contact 170 may be greater than that of second portion 170P2 of the first backside source/drain contact 170. A portion of the first portion 170P1 of the first backside source/drain contact 170 may extend over the line portion CHCT_L of the active region insulating pattern CHCT.

Although the width of the first backside source/drain contact 170 in the first direction DR1 is shown to increase sharply at the second side CHCT_LS2 of the line portion CHCT_L of the active region insulating pattern CHCT, embodiments are not limited thereto.

Although not shown, the shape of the second backside source/drain contact 270 may also be similar to the shape of the first backside source/drain contact 170.

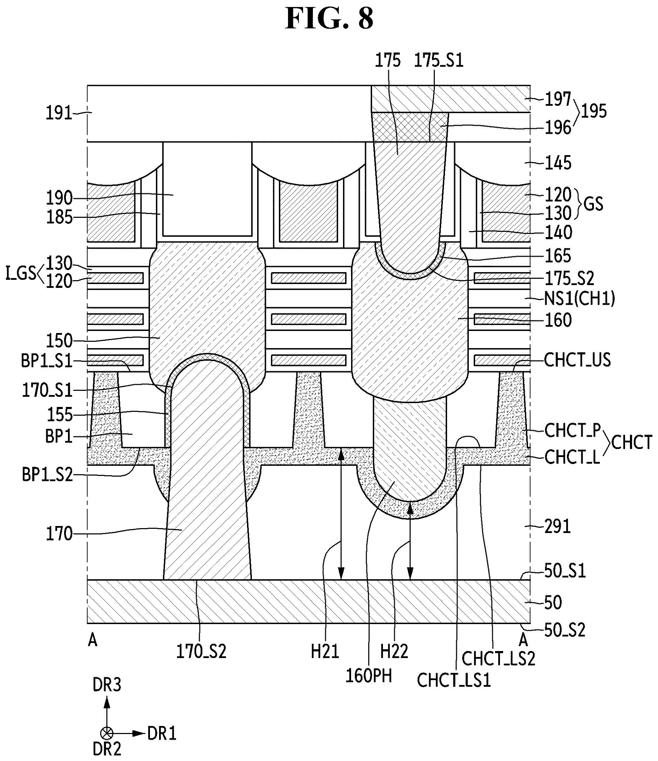

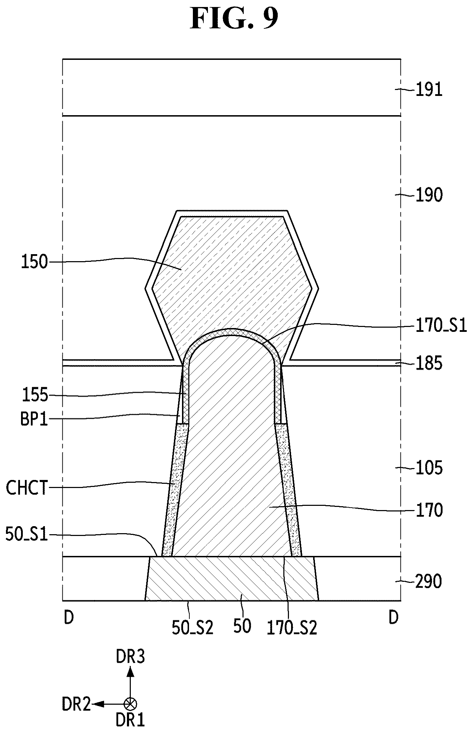

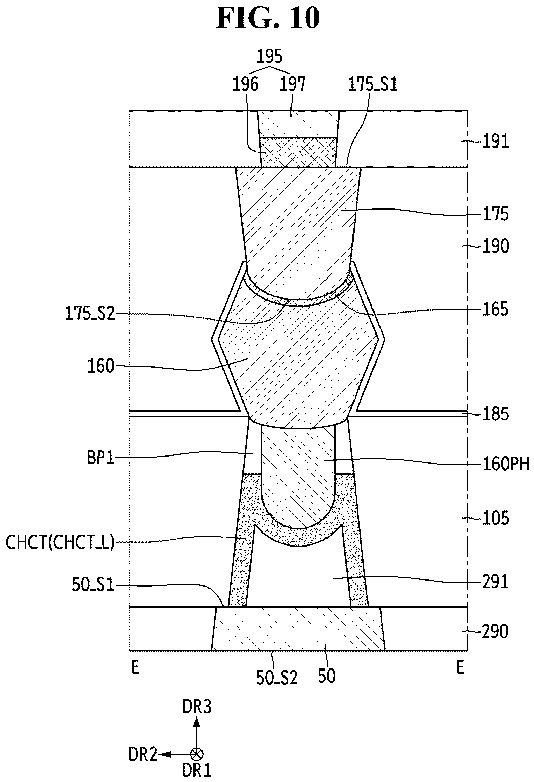

FIGS. 8, 9 and 10 are diagrams illustrating a semiconductor device according to one or more embodiments. For convenience of explanation, differences from those described using FIGS. 1 to 6 will be mainly explained. For reference, FIGS. 8 to 10 may be cross-sectional views taken along A-A, D-D, and E-E of FIG. 1.

Referring to FIGS. 8 to 10, the semiconductor device according to one or more embodiments may further include a sacrificial semiconductor pattern 160PH disposed between the second source/drain pattern 160 and the first backside wiring line 50.

The sacrificial semiconductor pattern 160PH may be disposed under the second source/drain pattern 160 connected to the frontside wiring line 197. The sacrificial semiconductor pattern 160PH may contact the second source/drain pattern 160. The sacrificial semiconductor pattern 160PH may be disposed between the protruding portions CHCT_P of the active region insulating patterns CHCT adjacent to each other in the first direction DR1.

At least a portion of the sacrificial semiconductor pattern 160PH may be disposed inside the first lower pattern BP1. In the semiconductor device according to one or more embodiments, a portion of the sacrificial semiconductor pattern 160PH may be disposed inside the first lower pattern BP1. The sacrificial semiconductor pattern 160PH may be a dummy semiconductor pattern (e.g., it may not provide any active electrical function within the semiconductor device). The remainder of the sacrificial semiconductor pattern 160PH may protrude in the third direction DR3 beyond the second side BP1_S2 of the first lower pattern BP1. The remainder of the sacrificial semiconductor pattern 160PH may protrude toward the first backside wiring line 50. A height H21 from the first side 50_S1 of the first backside wiring line 50 to the second side BP1_S2 of the first lower pattern BP1 may be greater than a height H22 from the first side 50_S1 of the first backside wiring line 50 to the lowermost portion of the sacrificial semiconductor pattern 160PH.

In the semiconductor device according to one or more embodiments, the active region insulating pattern CHCT may contact the sacrificial semiconductor pattern 160PH. The active region insulating pattern CHCT may contact the sacrificial semiconductor pattern 160PH that protrudes beyond the second side BP1_S2 of the first lower pattern BP1. The line portion CHCT_L of the active region insulating pattern CHCT may extend along the profile (e.g., the portion of the surface) of the sacrificial semiconductor pattern 160PH that protrudes beyond the second side BP1_S2 of the first lower pattern BP1.

The sacrificial semiconductor pattern 160PH may include a semiconductor material. For example, the sacrificial semiconductor pattern 160PH may include a material having an etch selectivity with respect to the first lower pattern BP1. When the first lower pattern BP1 includes silicon, the sacrificial semiconductor pattern 160PH may include, but is not limited to, silicon germanium.

The sacrificial semiconductor pattern 160PH may be disposed under a fourth source/drain pattern (260 of FIG. 3) connected to the frontside wiring line 197.

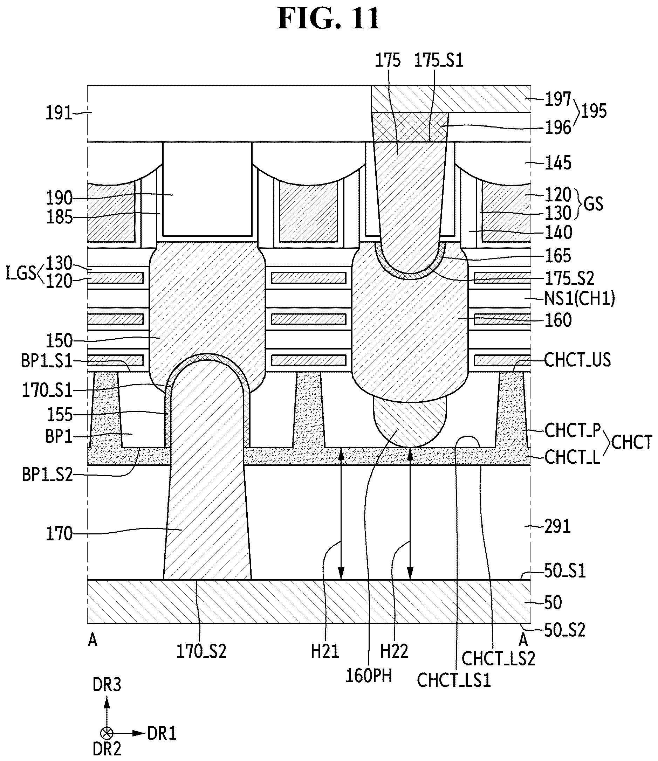

FIG. 11 is a diagram illustrating a semiconductor device according to one or more embodiments. For convenience of explanation, differences from those described using FIGS. 8 to 10 will be mainly described.

Referring to FIG. 11, in the semiconductor device according to one or more embodiments, the entire sacrificial semiconductor pattern 160PH may be disposed inside the first lower pattern BP1.

A height H21 from the first side 50_S1 of the first backside wiring line 50 to the second side BP1_S2 of the first lower pattern BP1 may be equal to or smaller than a height H22 from the first side 50_S1 of the first backside wiring line 50 to the lowermost portion of the sacrificial semiconductor pattern 160PH. Accordingly, the sacrificial semiconductor pattern 160PH may not protrude beyond the second side BP1_S2 of the first lower pattern BP1.

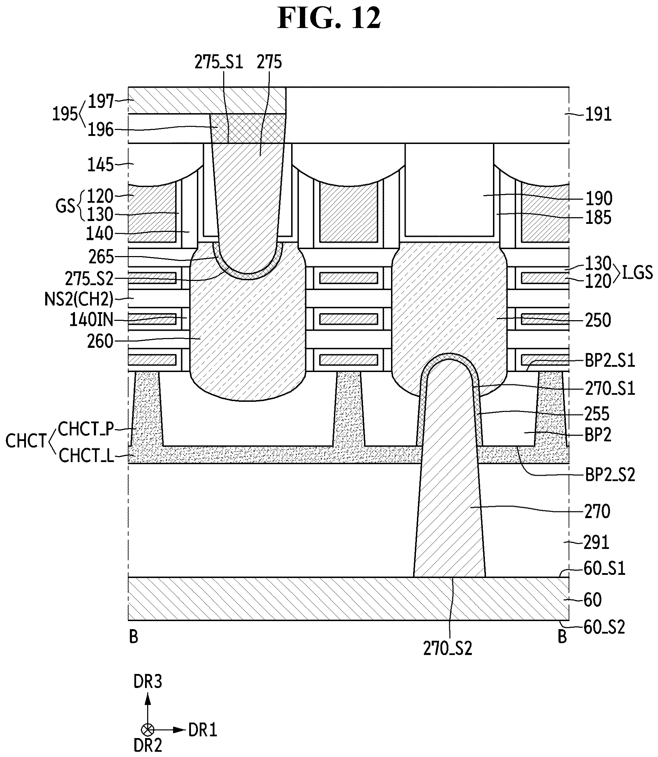

FIG. 12 is a diagram illustrating a semiconductor device according to one or more embodiments. For convenience of explanation, differences from those described using FIGS. 1 to 6 will be mainly described.

Referring to FIG. 12, the semiconductor device according to one or more embodiments may further include an inner spacer 140IN which is disposed between the second lower pattern BP2 and the second sheet pattern NS2, and between the second sheet patterns NS2 adjacent to each other in the third direction DR3.

The inner spacer 140IN may be disposed between the third source/drain pattern 250 and the inner gate structure I_GS, and between the fourth source/drain pattern 260 and the inner gate structure I_GS.

The inner spacer 140IN may include an insulating material.

As an example, the inner spacer 140IN may be disposed between the first lower pattern BP1 and the first sheet pattern NS1, and between the first sheet patterns NS1 adjacent to each other in the third direction DR3. As another example, the inner spacer 140IN may not be disposed between the first lower pattern BP1 and the first sheet pattern NS1, and between the first sheet patterns NS1 adjacent to each other in the third direction DR3.

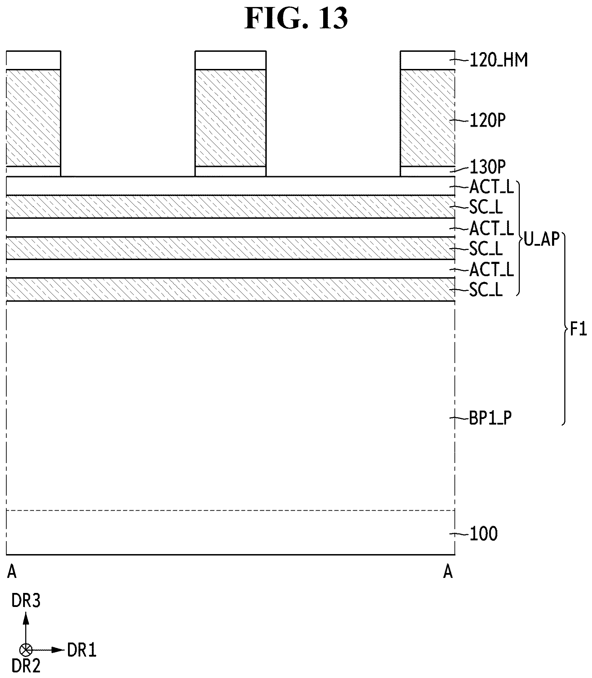

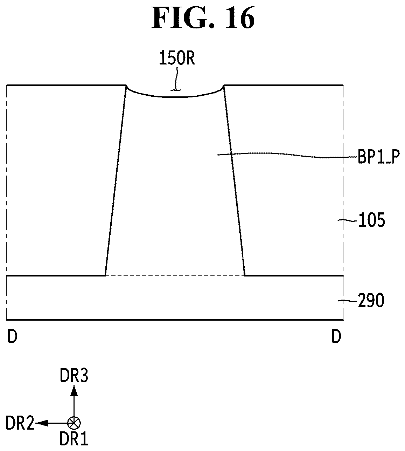

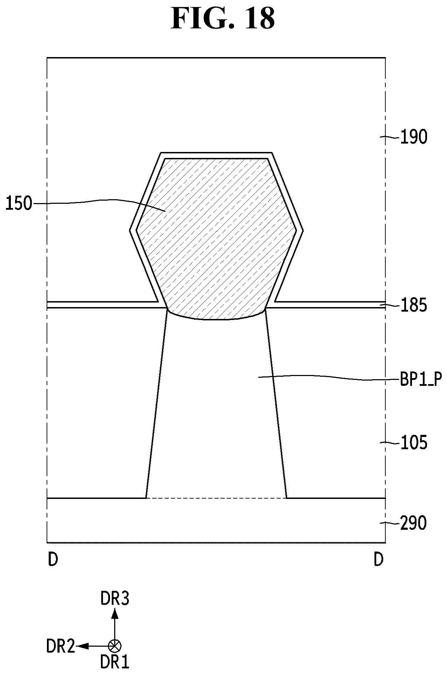

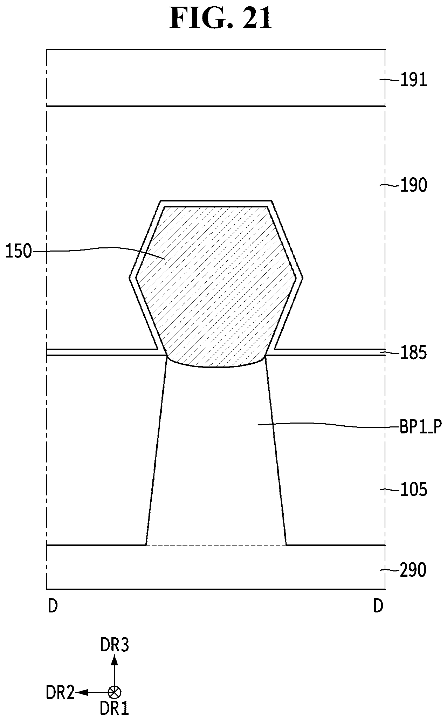

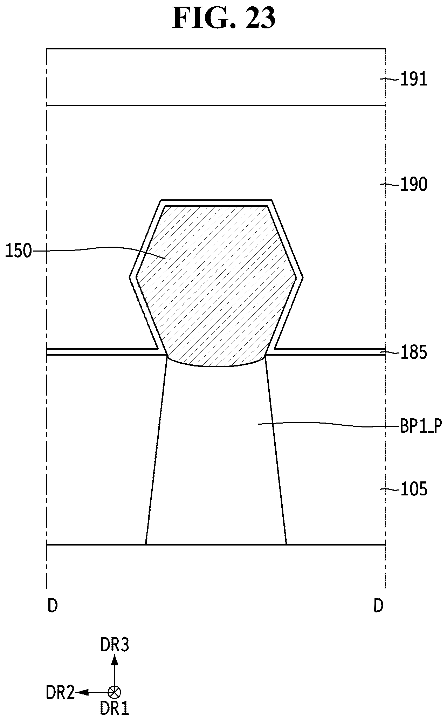

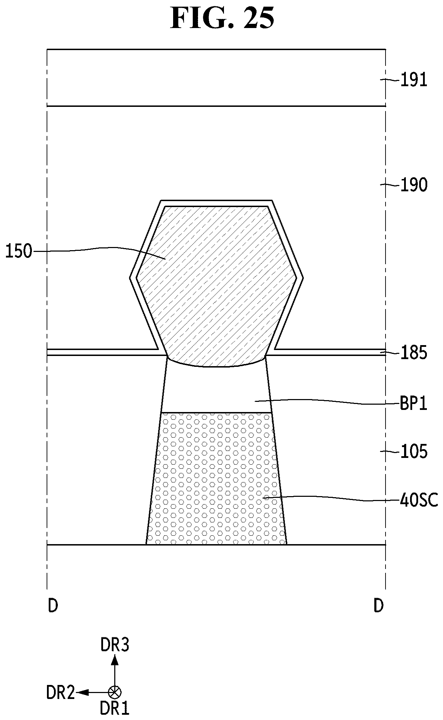

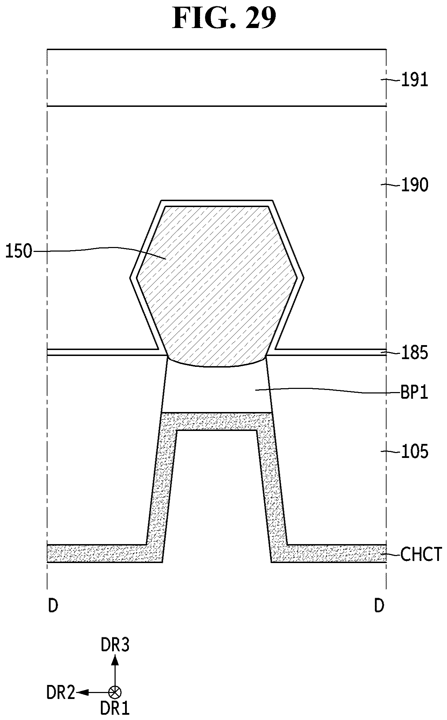

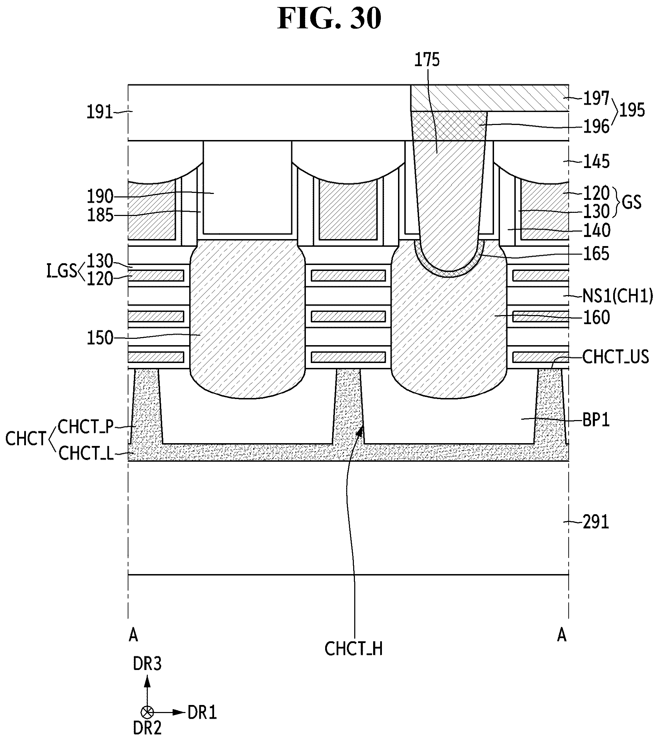

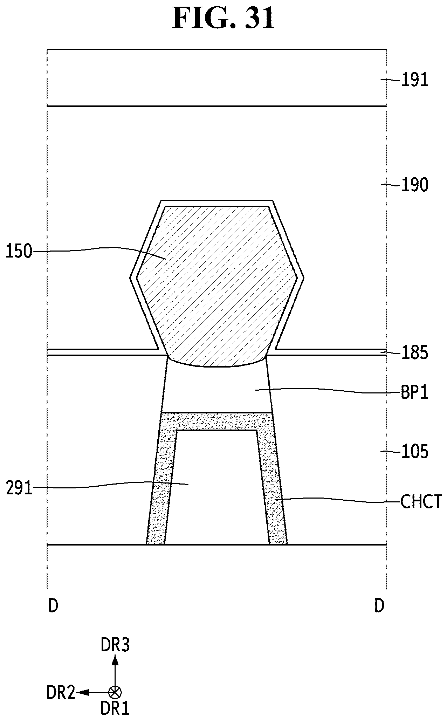

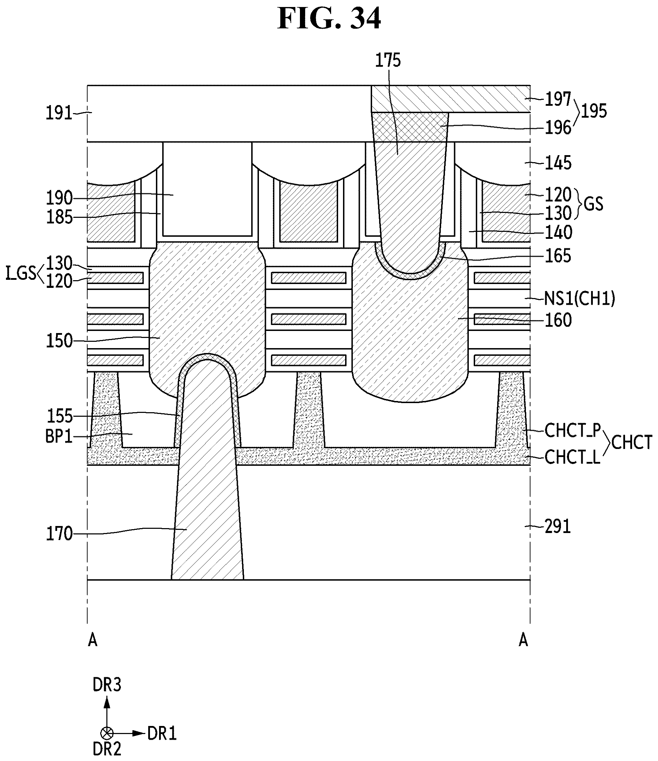

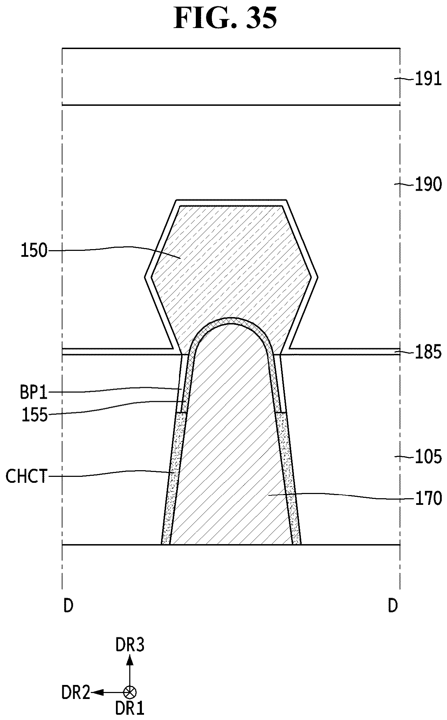

FIGS. 13, 14, 15, 16, 17, 18, 19, 20, 21, 22, 23, 24, 25, 26, 27, 28, 29, 30, 31, 32, 33, 34 and 35 are intermediate diagrams illustrating a method for fabricating a semiconductor device according to one or more embodiments.

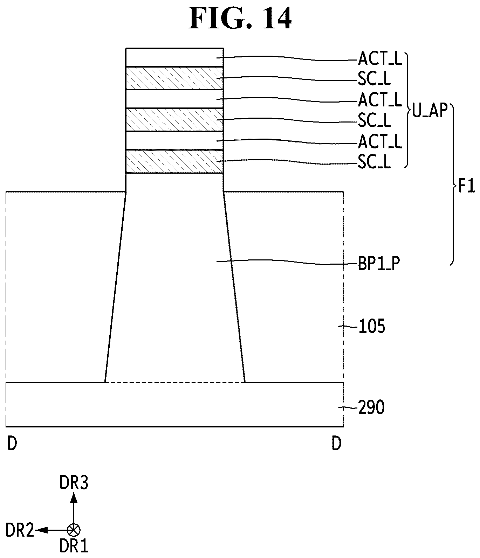

Referring to FIGS. 13 and 14, a fin-shaped pattern F1 may be formed on a substrate 100.

The substrate 100 may be bulk silicon or silicon-on-insulator (SOI). In contrast, the substrate 100 may be a silicon substrate or may include other materials, for example, silicon germanium, silicon germanium-on-insulator (SGOI), indium antimonide, lead telluride, indium arsenide, indium phosphide, gallium arsenide or gallium antimonide.

The fin-shaped pattern F1 may include a pre-lower pattern BP1_P and an upper pattern U_AP. The upper pattern U_AP may include a plurality of sacrificial channel patterns SC_L and a plurality of active patterns ACT_L that are alternately stacked on the pre-lower pattern BP1_P.

For example, the sacrificial channel patterns SC_L may each include a silicon-germanium film. The active patterns ACT_L may include a silicon film.

Subsequently, a field insulating film 105 may be formed on the substrate 100. The field insulating film 105 may cover a portion of the side wall of the fin-shaped pattern F1.

Next, a dummy gate insulating film 130P, a dummy gate electrode 120P, and a dummy gate capping film 120_HM may be formed on the upper pattern U_AP and the field insulating film 105. The dummy gate electrode 120P may intersect the fin-shaped pattern F1.

The dummy gate insulating film 130P may include, but is not limited to, silicon oxide. The dummy gate electrode 120P may include, but is not limited to, polysilicon. The dummy gate capping film 120_HM may include, but is not limited to, silicon nitride.

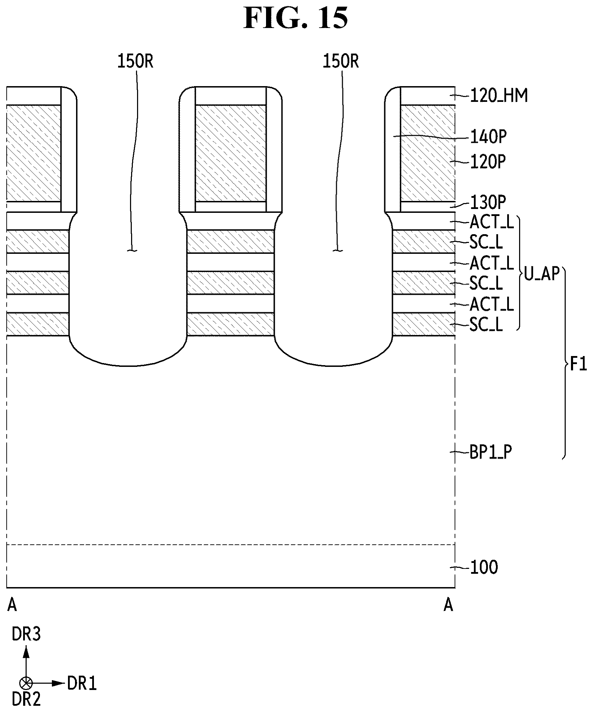

Referring to FIGS. 15 to 16, a pre-gate spacer 140P may be formed on a side wall of the dummy gate electrode 120P.

While the pre-gate spacer 140P is formed, a source/drain recess 150R may be formed inside the upper pattern U_AP, using the dummy gate electrode 120P as a mask. The bottom side of the source/drain recess 150R may be defined by a pre-lower pattern BP1_P.

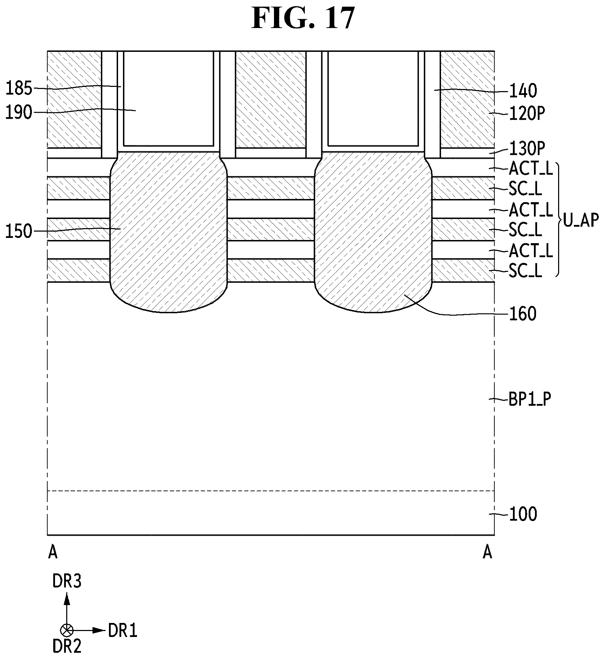

Referring to FIGS. 17 to 18, the first source/drain pattern 150 and the second source/drain pattern 160 may be formed inside the source/drain recess 150R.

Before the first source/drain pattern 150 and the second source/drain pattern 160 are formed, a sacrificial semiconductor pattern (160PH of FIG. 8) may be formed inside the pre-lower pattern BP1_P.

Next, a source/drain etch stop film 185 and a first frontside interlayer insulating film 190 may be formed sequentially on the first source/drain pattern 150 and the second source/drain pattern 160.

Next, a portion of the first frontside interlayer insulating film 190, a portion of the source/drain etch stop film 185, and the dummy gate capping film 120_HM may be removed to expose the upper side of the dummy gate electrode 120P. While the upper side of the dummy gate electrode 120P is exposed, a gate spacer 140 may be formed.

Referring to FIGS. 17 to 19, the dummy gate insulating film 130P and the dummy gate electrode 120P may be removed to expose the upper pattern U_AP between the gate spacers 140.

Next, the sacrificial channel pattern SC_L may be removed to form a first channel pattern CH1 including a plurality of first sheet patterns NS1. The first channel pattern NS1 may be connected to the first source/drain pattern 150 and the second source/drain pattern 160.

The sacrificial channel pattern SC_L may be removed to form a gate trench 120t between the gate spacers 140. When the sacrificial channel pattern SC_L is removed, a portion of the first source/drain pattern 150 and the second source/drain pattern 160 may be exposed.

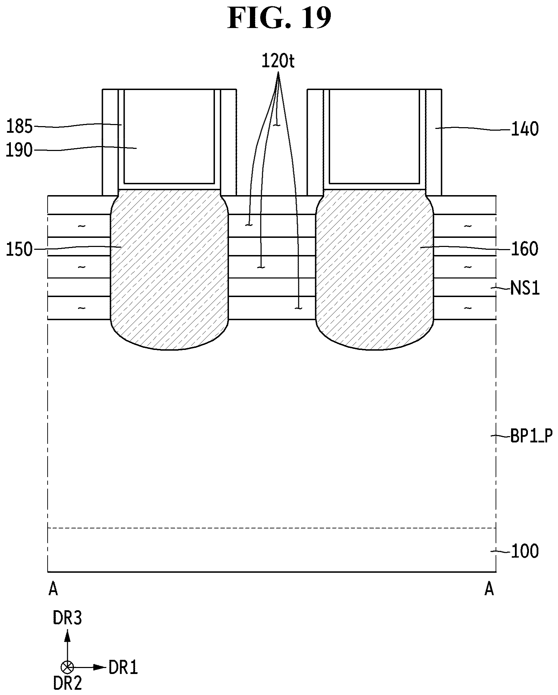

Referring to FIGS. 19 to 21, the gate insulating film 130 and the gate electrode 120 may be formed inside the gate trench 120t.

Further, the gate capping pattern 145 may be formed on the gate electrode 120.

Next, the first frontside source/drain contact 175 may be formed on the upper side of the substrate 100. The first frontside source/drain contact 175 may be connected to the second source/drain pattern 160. Before the first frontside source/drain contact 175 is formed, the first frontside contact silicide film 165 may be formed on the second source/drain pattern 160.

Next, the frontside wiring structure 195 may be formed on the gate structure GS and the first frontside source/drain contact 175. The frontside wiring structure 195 may be connected to the first frontside source/drain contact 175. The frontside wiring structure 195 may be formed in a second frontside interlayer insulating film 191 on the gate structure GS.

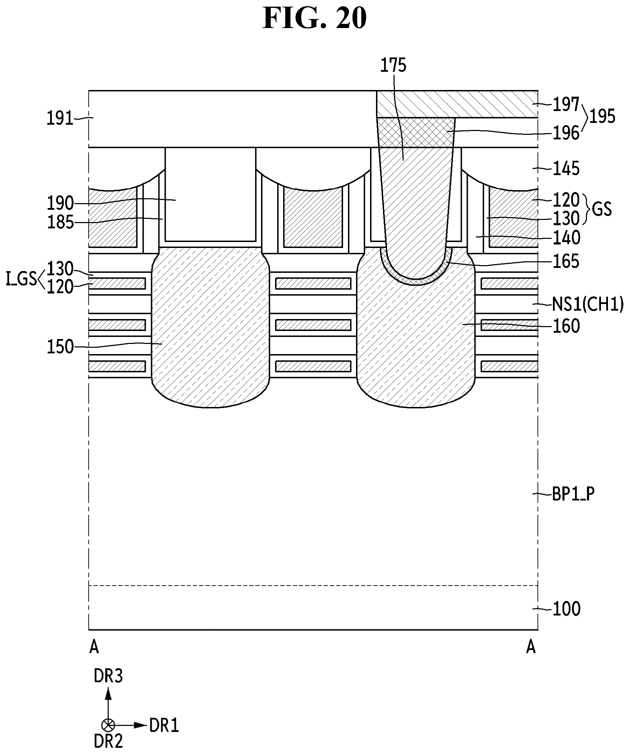

Referring to FIGS. 20 to 23, after forming the frontside wiring structure 195, the substrate 100 may be removed.

The substrate 100 may be removed to expose the pre-lower pattern BP1_P and the field insulating film 105.

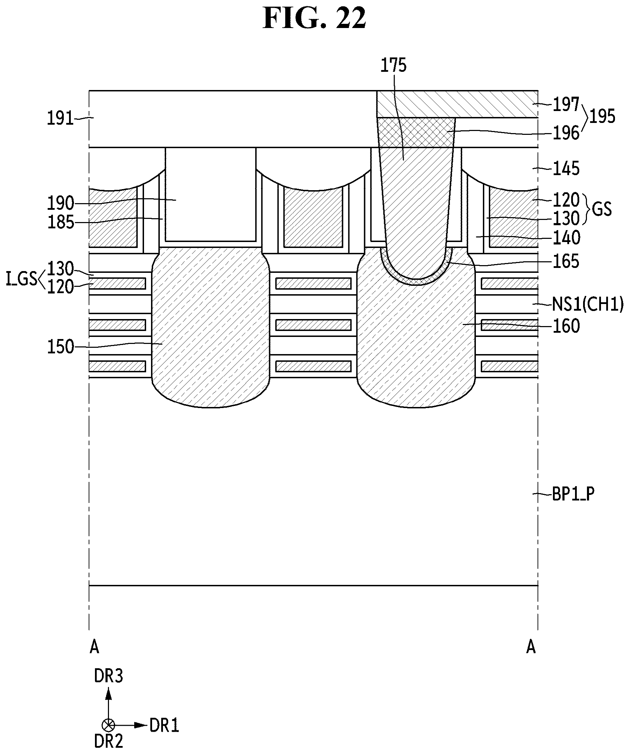

Referring to FIGS. 22 to 25, a first lower pattern BP1 may be formed by removing a portion of the exposed pre-lower pattern BP1_P.

A lower pattern trench that exposes the first lower pattern BP1 may be formed by removing a portion of the pre-lower pattern BP1_P. The lower pattern trench may be formed between the field insulating films 105. The lower pattern trench may extend in the first direction DR1.

After forming the first lower pattern BP1, a sacrificial filling film 40SC may be formed in a space from which a portion of the pre-lower pattern BP1_P is removed. The sacrificial filling film 40SC may fill the lower pattern trench. The field insulating film 105 may be disposed on the side wall of the sacrificial filling film 40SC.

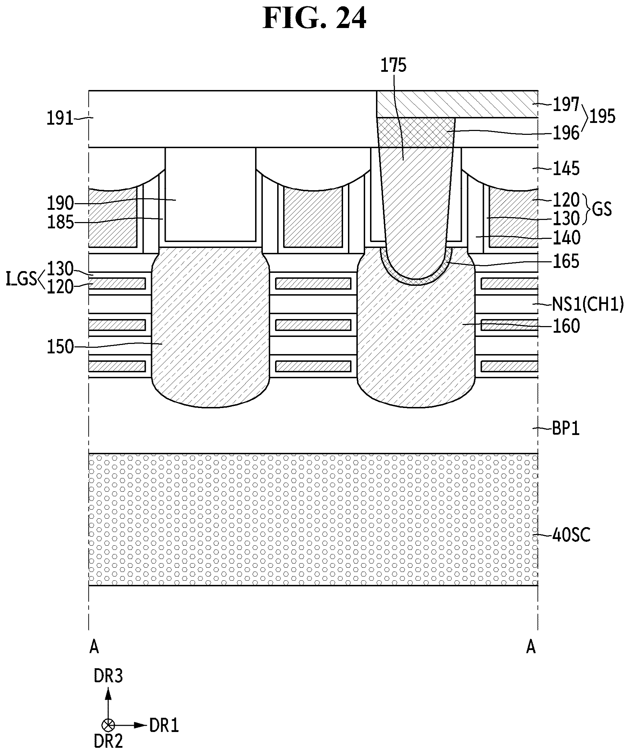

Referring to FIGS. 24 to 26, a plurality of active region insulating pattern holes CHCT_H may be formed.

Each insulating pattern hole CHCT_H may be formed inside the sacrificial filling film 40SC and the first lower pattern BP1. Each insulating pattern hole CHCT_H may extend through the sacrificial filling film 40SC and the first lower pattern BP1. Each insulating pattern hole CHCT_H may extend up to the inner gate structure I_GS to expose the gate structure GS.

While the insulating pattern holes CHCT_H are formed, the first lower pattern BP1 may be separated (e.g., into separate first lower patterns BP1 (e.g., separate sub-patterns, or portions, of the first lower pattern BP1)).

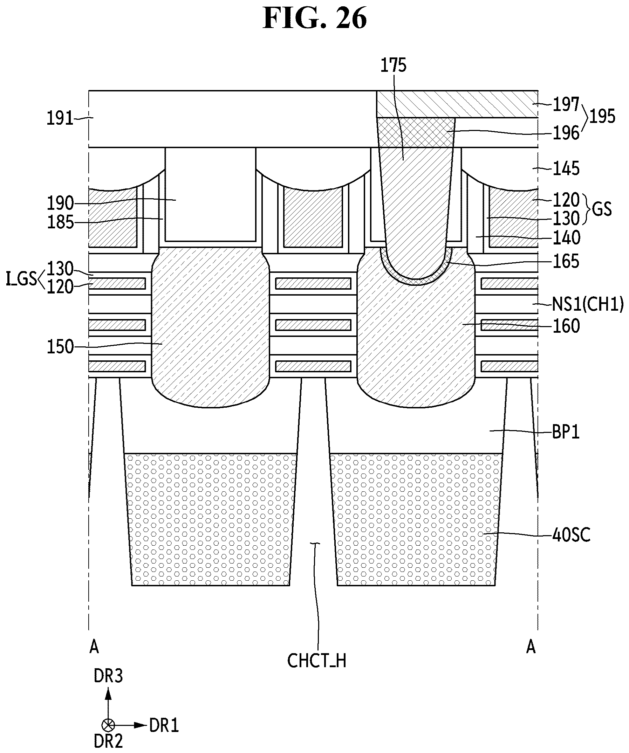

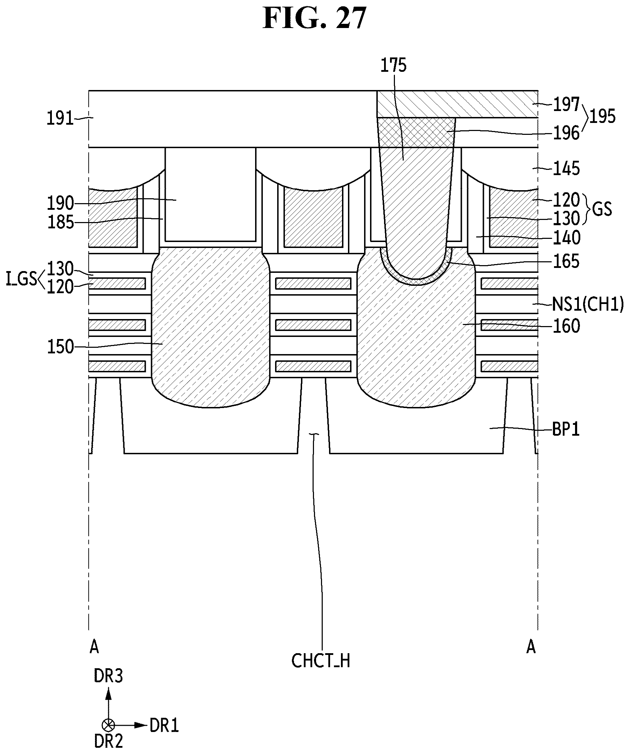

Referring to FIGS. 26 and 27, the sacrificial filling film 40SC may be removed.

By removing the sacrificial filling film 40SC, the second side of the first lower pattern BP1 may be exposed.

Referring to FIGS. 27 to 29, the active region insulating pattern CHCT may be formed on the first lower pattern BP1.

The active region insulating pattern CHCT may fill the insulating pattern holes CHCT_H. The active region insulating pattern CHCT may extend along the second side of the first lower pattern BP1. Accordingly, the protruding portion CHCT_P of the active region insulating pattern CHCT which fills the insulating pattern holes CHCT_H, and the line portion CHCT_L of the active region insulating pattern CHCT extending along the second side of the first lower pattern BP1 may be formed.

The active region insulating pattern CHCT may be formed along the side walls of the lower pattern trench formed between the field insulating films 105. The active region insulating pattern CHCT may be formed along exposed side of the field insulating film 105.

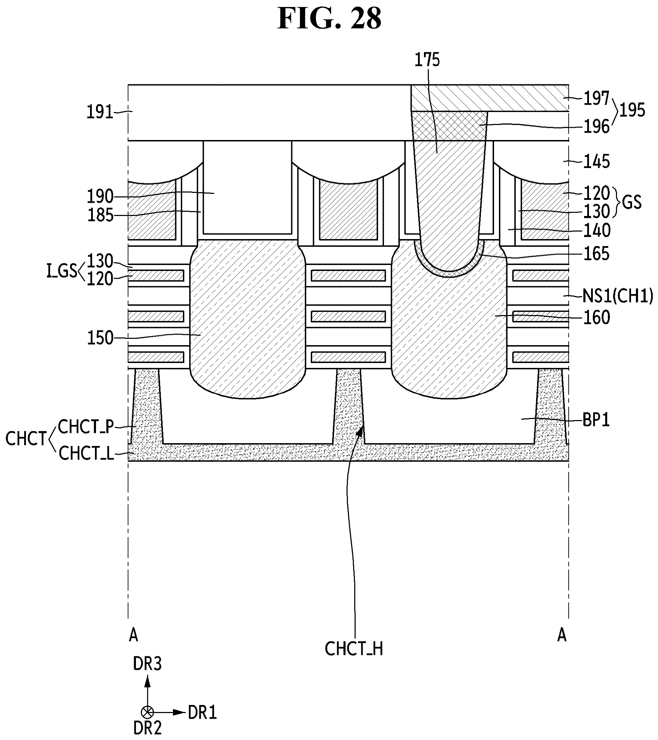

Referring to FIGS. 28 to 31, the backside insertion insulating film 291 may be formed on the active region insulating pattern CHCT.

The backside insertion insulating film 291 may fill the lower pattern trench that remains after the active region insulating pattern CHCT is formed. While the backside insertion insulating film 291 is formed, the active region insulating pattern CHCT formed along exposed side of the field insulating film 105 may be removed.

While the backside insertion insulating film 291 is formed, the active region insulating pattern CHCT formed along the exposed side of the field insulating film 105 may not be removed. In this case, in FIGS. 4 to 6, the active region insulating pattern CHCT may extend along the boundary between the field insulating film105 and the backside interlayer insulating film 290.

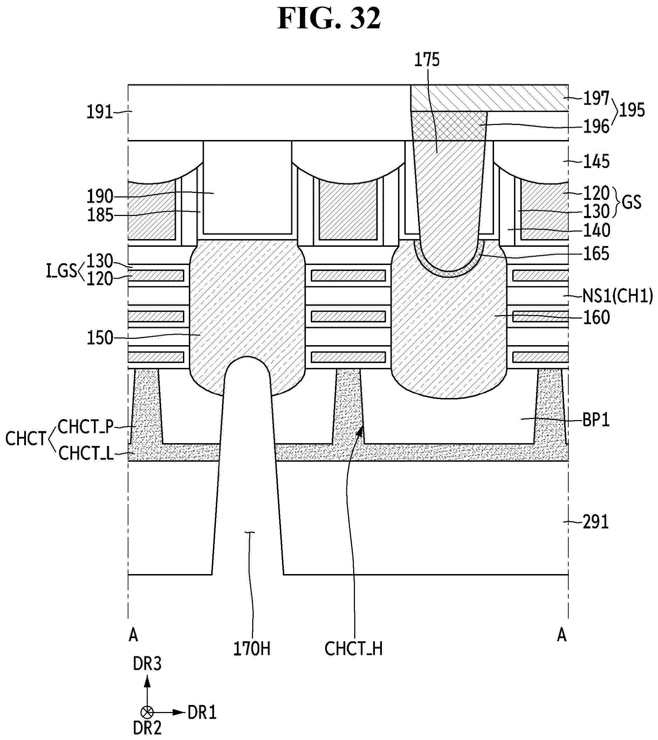

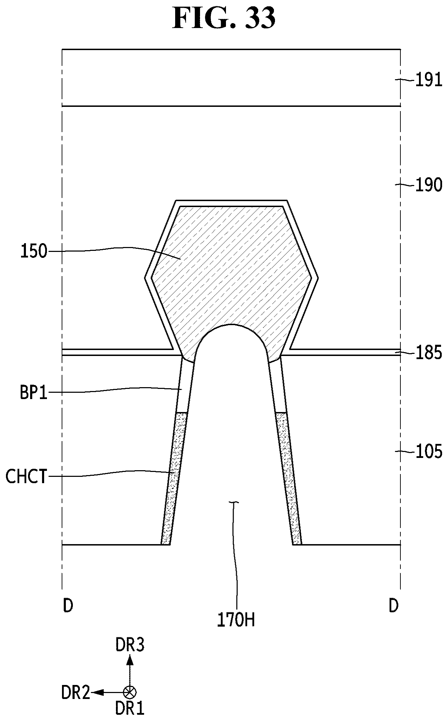

Referring to FIGS. 32 and 33, the backside contact hole 170H may be formed inside the active region insulating pattern CHCT and the backside insertion insulating film 291.

The backside contact hole 170H may expose the first source/drain pattern 150. The backside contact hole 170H may extend through the line portion CHCT_L of the active region insulating pattern CHCT and the first lower pattern BP1.

After forming the backside contact hole 170H which exposes the first source/drain pattern 150, the width of the backside contact hole 170H in the backside insertion insulating film 291 may be increased, by the use of a selective etching process.

Referring to FIGS. 32 to 35, the first backside source/drain contact 170 may be formed inside the backside contact hole 170H.

The first backside source/drain contact 170 may fill the backside contact hole 170H. The first backside source/drain contact 170 may be connected to the first source/drain pattern 150.

As an example, the first backside contact silicide film 155 may be formed before the first backside source/drain contact 170 is formed. As another example, the first backside contact silicide film 155 may be formed, while the first backside source/drain contact 170 is formed.

Next, referring to FIGS. 2 to 6, the first backside wiring line 50 connected to the backside source/drain contact 170 may be formed. The first backside wiring line 50 connected to the backside source/drain contact 170 may be formed in a backside interlayer insulating film 290.

According to another aspect of the present disclosure, there is provided a method for manufacturing a semiconductor device including forming a field insulating film which covers a portion of a side wall of a fin-shaped pattern, on a substrate, the fin-shaped pattern including a pre-lower pattern and an upper pattern disposed sequentially on the substrate, the upper pattern including a sacrificial channel pattern and an active pattern stacked alternately, forming a dummy gate electrode on the field insulating film and the fin-shaped pattern, the dummy gate electrode intersecting the fin-shaped pattern, forming a source/drain recess inside the fin-shaped pattern, by using the dummy gate electrode as a mask, forming a source/drain pattern inside the source/drain recess, removing the dummy gate electrode to form a gate trench after forming the source/drain pattern, removing the sacrificial channel pattern exposed by the gate trench to form a sheet pattern, forming a gate electrode inside the gate trench after forming the sheet pattern, removing the substrate to expose the field insulating film and the pre-lower pattern, removing a portion of the exposed pre-lower pattern to form a lower pattern, forming a sacrificial filling film in a space from which a portion of the pre-lower pattern is removed after forming the lower pattern, forming an insulating pattern hole which extends through the sacrificial filling film and the lower pattern, forming an active region insulating pattern which fills the insulating pattern hole after removing the sacrificial filling film, forming a backside insertion insulating film on the active region insulating pattern, forming a backside contact hole which exposes the source/drain pattern inside the active region insulating pattern and the backside insertion insulating film and forming a backside source/drain contact which fills the backside contact hole.

Embodiments described herein provide an improved semiconductor device. The semiconductor device has an improved active region insulating pattern CHCT. The active region insulating pattern CHCT includes a protruding portion CHCT_P that protrudes towards (e.g., contacts) the gate structure GS. This provides effective isolation between adjacent source/drain regions (i.e., preventing charge leaking through the lower patterns BP1 and BP2 between adjacent source/drain regions). The lower patterns BP1 and BP2 remain in the semiconductor device, therefore avoiding potential damage to the channel patterns CH1 and CH2 that may be caused by the complete removal of the pre-lower pattern BP1_P from beneath the channel patterns CH1 and CH2, and avoiding the need for an additional layer (e.g., semiconductor film) for protecting the source/drain regions from such damage. In addition, as the backside source/drain contacts 170 are formed independently of the active region insulating pattern CHCT, they can be formed more effectively, thereby avoiding the risk of air gaps within the backside source/drain contacts 170.

Embodiments are set out in the following Clauses:
Clause 1. A semiconductor device comprising:
   a backside wiring line comprising a first side and a second side opposite to the first side in a first direction;
   a lower pattern on the first side of the backside wiring line, the lower pattern comprising a first side and a second side opposite to the first side in the first direction, wherein the second side of the lower pattern faces the backside wiring line;
   a sheet pattern on the first side of the lower pattern, and that is spaced apart from the lower pattern in the first direction;
   a first source/drain pattern contacting the lower pattern and connected to the sheet pattern;
   a gate structure on the first side of the lower pattern, the gate structure comprising a gate insulating film and a gate electrode that enclose the sheet pattern, wherein the gate electrode extends in a second direction intersecting the first direction;
   an active region insulating pattern contacting the lower pattern and the gate structure; and
   a backside source/drain contact connected to the first source/drain pattern and the backside wiring line, the backside source/drain contact extending through the active region insulating pattern, and being below the first source/drain pattern in the first direction.
Clause 2. The semiconductor device of Clause 1, wherein the active region insulating pattern comprises a line portion that extends along the second side of the lower pattern, and a protruding portion that protrudes from the line portion of the active region insulating pattern in the first direction, and
   wherein the protruding portion of the active region insulating pattern contacts the gate structure.
Clause 3. The semiconductor device of Clause 2, wherein the backside source/drain contact does not contact the protruding portion of the active region insulating pattern.
Clause 4. The semiconductor device of Clause 2 or Clause 2, wherein the backside source/drain contact extends through the line portion of the active region insulating pattern.
Clause 5. The semiconductor device of any of Clauses 1-4, further comprising:
   a second source/drain pattern spaced apart from the first source/drain pattern in a third direction intersecting the first direction and the second direction, the second source/drain pattern being connected to the sheet pattern; and
   a sacrificial semiconductor pattern between the second source/drain pattern and the backside wiring line, and contacting the second source/drain pattern.
Clause 6. The semiconductor device of Clause 5, wherein a portion of the sacrificial semiconductor pattern protrudes in the first direction beyond the second side of the lower pattern.
Clause 7. The semiconductor device of Clause 5 or Clause 6, further comprising:
   a frontside wiring line on the first source/drain pattern and the second source/drain pattern, the frontside wiring line connected to the second source/drain pattern; and
   a frontside source/drain contact between the frontside wiring line and the second source/drain pattern.
Clause 8. A semiconductor device comprising:
   a backside wiring line comprising a first side and a second side opposite to the first side in a first direction;
   a lower pattern on the first side of the backside wiring line, the lower pattern comprising a first side and a second side opposite to the first side in the first direction, wherein the second side of the lower pattern faces the backside wiring line;
   a sheet pattern on the first side of the lower pattern, and that is spaced apart from the lower pattern in the first direction;
   a first source/drain pattern contacting the lower pattern and connected to the sheet pattern;
   a gate structure on the first side of the lower pattern, the gate structure comprising a gate insulating film and a gate electrode that enclose the sheet pattern, wherein the gate electrode extends in a second direction intersecting the first direction;
   an active region insulating pattern contacting the lower pattern and the gate structure; and
   a backside source/drain contact connected to the first source/drain pattern and the backside wiring line, and the backside source/drain contact being below the first source/drain pattern in the first direction,
   wherein the second side of the lower pattern is above a surface of the active region insulating pattern in the first direction.
Clause 9. The semiconductor device of Clause 8,
   wherein the active region insulating pattern comprises a line portion that extends along the second side of the lower pattern, and a protruding portion that protrudes from the line portion of the active region insulating pattern in the first direction, and
   wherein the backside source/drain contact extends through the line portion of the active region insulating pattern.
Clause 10. The semiconductor device of Clause 8 or Clause 9, further comprising:
   a second source/drain pattern spaced apart from the first source/drain pattern in a third direction intersecting the first direction and the second direction, the second source/drain pattern being connected to the sheet pattern; and
   a sacrificial semiconductor pattern between the second source/drain pattern and the backside wiring line, the sacrificial semiconductor pattern contacting the second source/drain pattern.
Clause 11. The semiconductor device of Clause 10, wherein, in the first direction, a height from the first side of the backside wiring line to the second side of the lower pattern is greater than a height from the first side of the backside wiring line to a lowermost portion of the sacrificial semiconductor pattern.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor device comprising:
a backside wiring line (50) comprising a first side (50_S1) and a second side (50_S2) opposite to the first side (50_S1) in a first direction;
a lower pattern (BP1) on the first side (50_S1) of the backside wiring line (50), the lower pattern (BP1) comprising a first side (BP1_S1) and a second side (BP1_S2) opposite to the first side (BP1_S1) in the first direction, wherein the second side (BP1_S2) of the lower pattern faces the backside wiring line (50);
a sheet pattern (NS1) on the first side (BP1_S1) of the lower pattern (BP1), wherein the sheet pattern (NS1) is spaced apart from the lower pattern (BP1) in the first direction;
a first source/drain pattern (150) on the lower pattern (BP1) and connected to the sheet pattern (NS1);
an active region insulating pattern (CHCT) contacting the lower pattern (BP1), the active region insulating pattern (CHCT) comprising a line portion (CHCT_L) and a protruding portion (CHCT_P), the line portion (CHCT_L) of the active region insulating pattern (CHCT) extending along the second side (BP1_S2) of the lower pattern (BP1), and the protruding portion (CHCT_P) of the active region insulating pattern (CHCT) protruding from the line portion (CHCT_L) of the active region insulating pattern (CHCT) toward the sheet pattern (NS1); and
a backside source/drain contact (170) connected to the first source/drain pattern (150) and the backside wiring line (50), the backside source/drain contact (170) being below the first source/drain pattern (150) in the first direction.

2. The semiconductor device of claim 1, wherein the backside source/drain contact (170) extends through the active region insulating pattern (CHCT).

3. The semiconductor device of claim 2, wherein the backside source/drain contact (170) extends through the line portion (CHCT_L) of the active region insulating pattern (CHCT).

4. The semiconductor device of any preceding claim, wherein the protruding portion (CHCT_P) of the active region insulating pattern (CHCT) extends to the first side (BP1_S1) of the lower pattern (BP).

5. The semiconductor device of any preceding claim, further comprising:
a second source/drain pattern (160) spaced apart from the first source/drain pattern (150) in a second direction intersecting the first direction, wherein the second source/drain pattern (160) is connected to the sheet pattern (NS1); and
a sacrificial semiconductor pattern (160PH) between the second source/drain pattern (160) and the backside wiring line (50), the sacrificial semiconductor pattern (160PH) contacting the second source/drain pattern (160).

6. The semiconductor device of claim 5, wherein, in the first direction a height from the first side (50_S1) of the backside wiring line (50) to the second side (BP1_S2) of the lower pattern (BP1) is greater than a height from the first side (50_S1) of the backside wiring line (50) to a lowermost portion of the sacrificial semiconductor pattern (160PH).

7. The semiconductor device of claim 6, wherein a portion of the sacrificial semiconductor pattern (160PH) protrudes in the first direction beyond the second side (BP1_S2) of the lower pattern (BP1).

8. The semiconductor device of claim 7, wherein the line portion (CHCT_L) of the active region insulating pattern (CHCT) extends in the second direction along the portion of the sacrificial semiconductor pattern (160PH) that protrudes beyond the second side (BP1_S2) of the lower pattern (BP1).

9. The semiconductor device of any of claims 6-8, further comprising:
a frontside wiring line (197) on the first source/drain pattern (150) and the second source/drain pattern (160), the frontside wiring line (197) being connected to the second source/drain pattern (160); and
a frontside source/drain contact (175) between the frontside wiring line (197) and the second source/drain pattern (160).

10. The semiconductor device of any preceding claim, wherein the first source/drain pattern (150) contacts the lower pattern (BP1).

11. The semiconductor device of any preceding claim, further comprising:
a gate structure (GS) on the first side (BP1_S1) of the lower pattern (BP1), the gate structure (GS) comprising a gate insulating film (130) and a gate electrode (120) that enclose the sheet pattern (NS1).

12. The semiconductor device of claim 10 wherein the protruding portion (CHCT_P) of the active region insulating pattern contacts (CHCT) the gate structure (GS).

13. The semiconductor device of claim 11 or claim 12, wherein:
the gate electrode extends in a third direction intersecting the first direction; and
the active region insulating pattern (CHCT) contacts the gate structure (GS).

14. The semiconductor device of any preceding claim, wherein the backside source/drain contact (170) does not contact the protruding portion (CHCT_P) of the active region insulating pattern (CHCT).

15. The semiconductor device of any preceding claim, wherein the backside source/drain contact (170) extends through the line portion (CHCT_L) of the active region insulating pattern (CHCT).
